# EUROPEAN PATENT SPECIFICATION

(11) **EP 4 212 998 B1**
(45) Date of publication and mention of the grant of the patent: **20.05.2026**
(21) Application number: 21866538.8
(22) Date of filing: 25.08.2021
(51) Int. Cl.: G06F 3/041, H03K 17/96

(54) **SENSOR UNIT, AND ATTACHING STRUCTURE OF SENSOR UNIT AND ATTACHMENT OBJECT**
SENSOREINHEIT UND BEFESTIGUNGSSTRUKTUR EINER SENSOREINHEIT UND BEFESTIGUNGSOBJEKT
UNITÉ DE CAPTEUR, ET STRUCTURE DE FIXATION D'UNITÉ DE CAPTEUR ET OBJET DE FIXATION

(30) Priority: 14.09.2020 JP 2020153687; 24.08.2021 JP 2021136232
(43) Date of publication of application: 19.07.2023
(73) Proprietor: HOSIDEN CORPORATION, Yao-shi, Osaka 581-0071 (JP)
(72) Inventor: SHIGA, Naoki, Yao-shi, Osaka 581-0071 (JP); ISODA, Takeshi, Yao-shi, Osaka 581-0071 (JP)
(74) Representative: Gill Jennings & Every LLP
(86) International application number: PCT/JP2021/031158
(87) International publication number: WO 2022/054578

(56) References cited:
- WO-A1-2013/168338
- WO-A1-2015/121955
- JP-A- 2012 033 063
- JP-A- 2014 159 184
- JP-A- 2018 067 244
- JP-A- H09 245 559
- JP-A- H11 345 081
- US-A1- 2006 253 988
- US-A1- 2016 338 198
- US-A1- 2018 061 634

## Description

### Technical Field

The invention relates to a sensor unit, and an attachment structure for the sensor unit and an attachment target.

### Background Art

Patent Literature below describes an attachment structure for a vehicle interior component and a capacitive touch switch. The vehicle interior component includes a housing, a cushion layer covering a surface of the housing, and an outer surface layer covering the cushion layer. The touch switch is securely held between the housing and the cushion layer.

### Citation List

### Patent Literature

Patent Literature 1: Japanese Unexamined Patent Application Publication No. 2019-188919. Other previously proposed arrangements are disclosed in US 2016/338198 A1, US 2006/253988 A1 and US 2018/061634 A1.

### Summary of Invention

### Technical Problem

A touch switch is attached to the vehicle interior component in the following manner. First, the touch switch is fixed onto the housing. Then, the cushion layer is bonded to the housing such that the cushion layer covers the touch switch. The touch switch is thus disposed between the housing and the cushion layer. Such bonding of the cushion layer is a difficult task because of the necessity to bond the cushion layer to the housing while being careful not to get air caught between the touch switch and the cushion layer.

The invention provides a sensor unit easily attachable to an attachment target, and an attachment structure for the sensor unit and the attachment target.

### Solution to Problem

An attachment structure for a sensor unit and an attachment target as defined in claim 1.

### Brief Description of Drawings

Fig. 1A is a schematic cross-sectional view of a connection structure for a sensor unit and an attachment target according to a first embodiment of the invention.
Fig. 1B is a schematic cross-sectional view of the connection structure of the first embodiment, with the sensor unit and the attachment target separated.
Fig. 2 is a schematic exploded perspective view of the attachment structure of the first embodiment.
Fig. 3A is a schematic cross-sectional view of a first variant of the attachment target of the attachment structure of the first embodiment.
Fig. 3B is a schematic cross-sectional view of a second variant of the attachment target of the attachment structure of the first embodiment.
Fig. 4A is a schematic cross-sectional view of a first variant of the sensor unit of the attachment structure of the first embodiment.
Fig. 4B is a schematic cross-sectional view of a second variant of the sensor unit of the attachment structure of the first embodiment.
Fig. 4C is a schematic cross-sectional view of a third variant of the sensor unit of the attachment structure of the first embodiment.
Fig. 5A is a schematic cross-sectional view of a connection structure for a sensor unit and an attachment target according to a second embodiment of the invention.
Fig. 5B is a schematic cross-sectional view of the connection structure of the second embodiment, with the sensor unit and the attachment target separated.
Fig. 6A is a schematic cross-sectional view of a first variant of the sensor unit of the attachment structure of the second embodiment.
Fig. 6B is a schematic cross-sectional view of a second variant of the sensor unit of the attachment structure of the second embodiment.
Fig. 6C is a schematic cross-sectional view of a third variant of the sensor unit of the attachment structure of the second embodiment.
Fig. 7A is a schematic cross-sectional view of a connection structure for a sensor unit and an attachment target according to a third embodiment of the invention.
Fig. 7B is a schematic cross-sectional view of the connection structure of the third embodiment, with the sensor unit and the attachment target separated.
Fig. 8A is a schematic cross-sectional view of a first variant of the sensor unit of the attachment structure of the third embodiment.
Fig. 8B is a schematic cross-sectional view of a second variant of the sensor unit of the attachment structure of the third embodiment.
Fig. 9A is a schematic cross-sectional view of a connection structure for a sensor unit and an attachment target according to a fourth embodiment of the invention.
Fig. 9B is a schematic cross-sectional view of the connection structure of the fourth embodiment, with the sensor unit and the attachment target separated.
Fig. 10A is a schematic cross-sectional view of a first variant of the sensor unit of the attachment structure of the fourth embodiment.
Fig. 10B is a schematic cross-sectional view of a second variant of the sensor unit of the attachment structure of the fourth embodiment.

### Description of Embodiments

The following description describes a plurality of embodiments of the invention, including first, second, third, and fourth embodiments and modification examples thereof. It should be noted that constituents of the embodiments and their modification examples to be described may be combined in any possible manner. Also, materials, shapes, dimensions, numbers, arrangements, etc. of the constituents of the various aspects of the embodiments and their modification examples will be discussed below as examples only and may be modified as long as they achieve similar functions.

### First embodiment

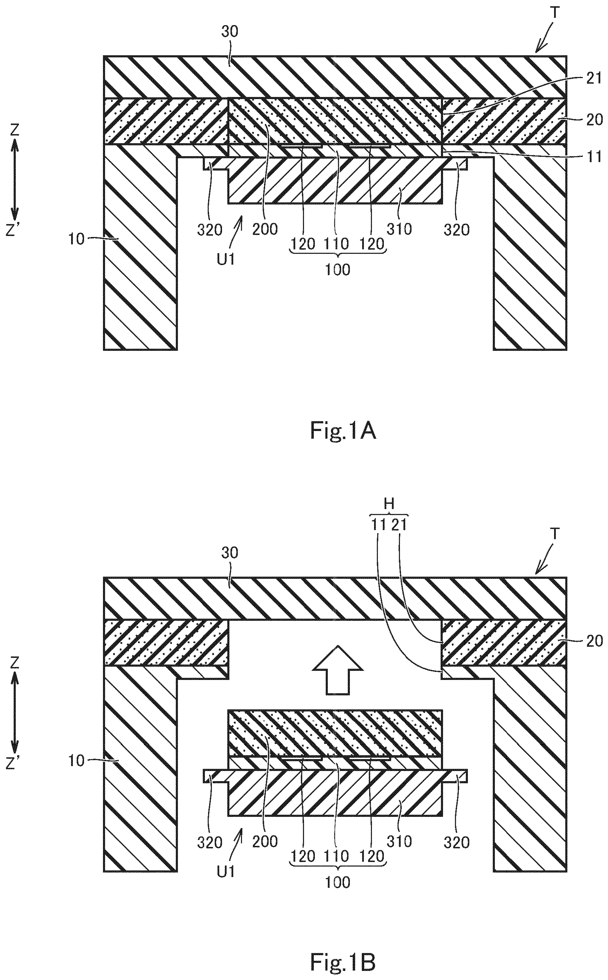

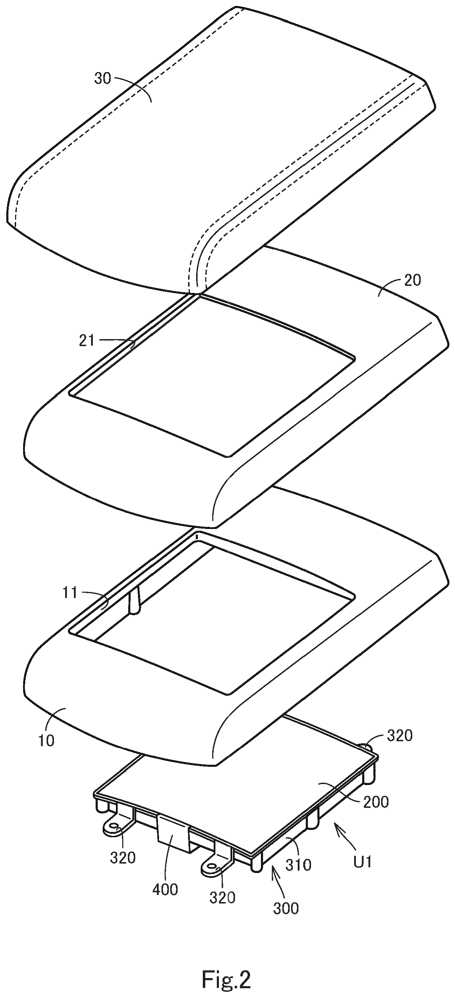

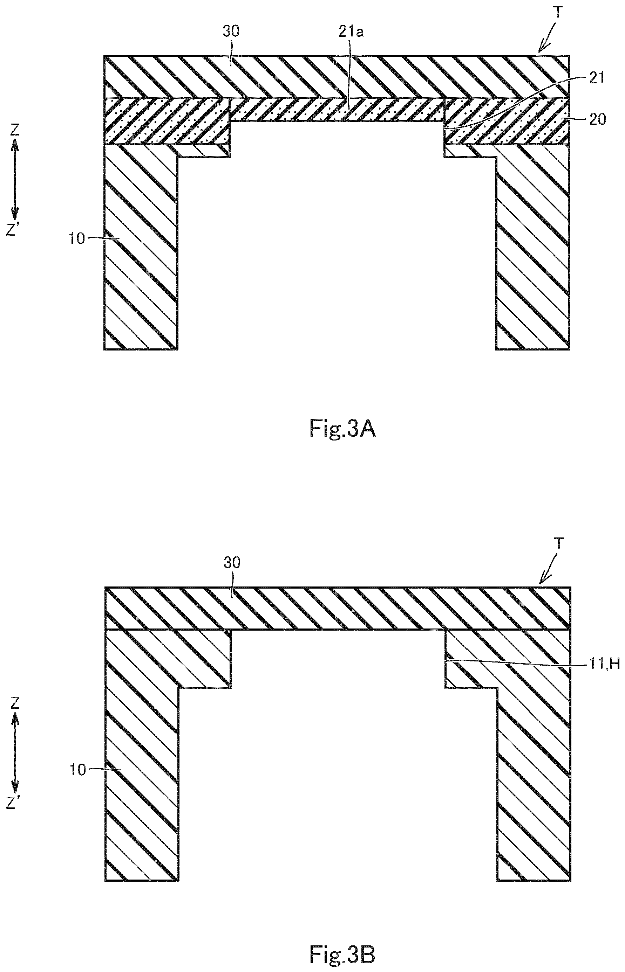

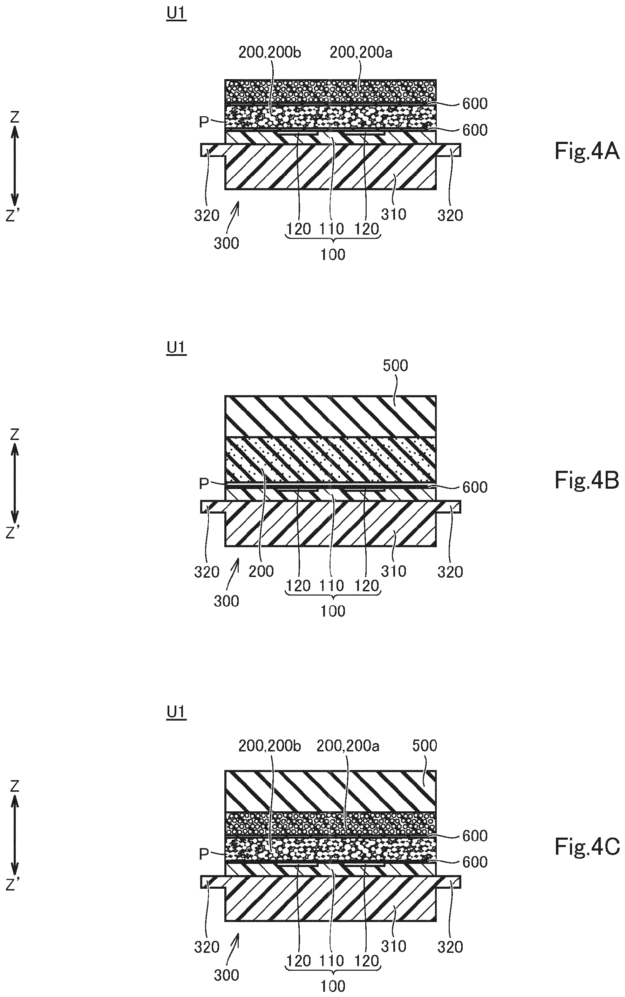

An attachment structure for a sensor unit U1 (which may be referred to simply as "unit U1") and an attachment target T according to a plurality of embodiments of the invention, including the first embodiment and modification examples thereof, will be hereinafter described with reference to Figs. 1A to 4C. Figs. 1A to 2 illustrate the attachment structure of the first embodiment. Fig. 3A illustrates a first variant of the attachment target T of the attachment structure of the first embodiment, and Fig. 3B illustrates a second variant of the attachment target T of the attachment structure of the first embodiment. Fig. 4A illustrates a first variant of the unit U1 of the attachment structure of the first embodiment, Fig. 4B illustrates a second variant of the unit U1 of the attachment structure of the first embodiment, and Fig. 4C illustrates a third variant of the unit U1 of the attachment structure of the first embodiment. Figs. 1A, 1B, and 3A to 4C show a Z-Z' direction (first direction). The Z-Z' direction includes a Z' direction (one side in the first direction) and a Z direction (the other side in the first direction).

The attachment target T may be, for example, an interior part of an automobile (e.g., a console (see Figs. 1A to 2), an armrest, a seat, a dashboard, a steering wheel, an inner panel of a door, or a headliner (lining)); furniture (e.g., a sofa, a stool, a chair, a desk, a table, etc.); a portable information terminal, such as a smartphone; a stationary information terminal to be operated by a user (e.g., an automated teller machine (ATM), a ticket vending device, a reception terminal for making a loan contract for cash advances or the like services, a multimedia terminal for making a ticket reservation or a product purchase application, a vending machine, a point of sales (POS) terminal, a ticketing machine for issuing boarding passes or other tickets installed at an airport, a bullet train station, etc., an amusement device (e.g., a pachinko machine, a slot machine in a pachinko parlor, a slot machine, an arcade game, or the like)); or the like.

The attachment target T includes a housing 10 (see Figs. 1A to 3B). The housing 10 is a housing of the interior part of an automobile, the housing of furniture, the portable information terminal, the stationary information terminal, or the like described above.

The attachment target T may further include a cushion layer 20 (see Figs. 1A to 3A). The cushion layer 20 may be constituted by a foaming material made of polypropylene (PP), polyethylene (PE), urethane, silicone, or the like; a gel material made of silicone, urethane, or the like; a fiber material formed by three-dimensionally weaving polyester or other synthetic fibers; or a soft resin material of an elastomer or the like. The cushion layer 20 covers the housing 10 at least partly from the Z-direction side. In other words, the cushion layer 20 may cover the housing 10 entirely or partly from the Z-direction side. The cushion layer 20 may, but is not required to, be fixed to the housing 10 with an adhesive, a plurality of screws, a plurality of pins, and/or other means. The cushion layer 20 may be omitted (see Fig. 3B).

The attachment target T may further include an outer surface layer 30 (see Figs. 1A to 3B). The outer surface layer 30 is composed of a natural, artificial, or synthetic leather, a cloth of fibrous material, such as a woven fabric or knitted fabric, a synthetic resin film, or the like material.

Where the cushion layer 20 is provided (see Figs. 1A to 3A), the outer surface layer 30 covers the cushion layer 20 and the housing 10 from the Z-direction side. Where the cushion layer 20 covers the housing 10 entirely, the outer surface layer 30 may cover the cushion layer 20 and the housing 10 entirely from the Z-direction side, or alternatively cover the cushion layer 20 and the housing 10 partly from the Z-direction side. Where the cushion layer 20 covers the housing 10 partly, the outer surface layer 30 may cover the cushion layer 20 and the housing 10 entirely from the Z-direction side, cover the cushion layer 20 and the housing 10 partly from the Z-direction side, or cover the cushion layer 20 entirely and cover the housing 10 partly from the Z-direction side.

Where the cushion layer 20 is not provided (see Fig. 3B), the outer surface layer 30 covers the housing 10 from the Z-direction side. The outer surface layer 30 may cover the housing 10 entirely from the Z-direction side, or alternatively cover the housing 10 partly from the Z-direction side.

The outer surface layer 30 of any of the aspects described above may preferably, but is not required to, be fixed to the cushion layer 20 and/or to the housing 10 with an adhesive, a plurality of screws, a plurality of pins, and/or other means. The outer surface layer 30 may be omitted.

The attachment target T includes a hole H. The hole H is provided in the attachment target T and opens out at least in the Z' direction. The hole H may be a blind hole opening out in the Z' direction and being closed on the Z-direction side. The hole H of the attachment target T may further include any of configurations (1) to (3) below, for example.
(1) Where the attachment target T includes the housing 10, the cushion layer 20, and the outer surface layer 30 (see Figs. 1A and 1B), the hole H includes a first hole 11 of the housing 10 and a second hole 21 of the cushion layer 20. The first hole 11 is a through hole extending through the housing 10 in the Z-Z' direction. The second hole 21 is a through hole extending through the cushion layer 20 in the Z-Z' direction, is located on the Z-direction side relative to the first hole 11, and communicates with the first hole 11. The first hole 11 may preferably, but is not required to be, have a shape as viewed from the Z'-direction side and dimensions (projected area) as viewed from the Z'-direction side that are substantially identical to those of the second hole 21. The outer surface layer 30 may close the second hole 21 of the cushion layer 20 from the Z-direction side. A portion of the outer surface layer 30 that is located on the Z-direction side relative to the hole H forms a bottom portion of the hole H. The surface on the Z-direction side of the bottom portion includes a touch region to be contacted by a detection target, such as a finger or a stylus, from the Z-direction side.
(2) A hole H of configuration (2) includes the same configuration as the hole H of configuration (1), except that the hole H is a blind hole with the second hole 21 opening out in the Z' direction and the Z-direction side closed, and that the cushion layer 20 includes a bottom portion 21a on the Z-direction side relative to the second hole 21 (see Fig. 3A). The bottom portion 21a may be a cushion layer provided separately from the cushion layer 20 (see Fig. 3A), or may be integral with the cushion layer 20. The bottom portion of the hole H is constituted by the bottom portion 21a and a portion of the outer surface layer 30 that is located on the Z-direction side relative to the hole H. The surface on the Z-direction side of the portion of the outer surface layer 30 located on the Z-direction side relative to the hole H includes the touch region.
(3) Where the attachment target T does not include the cushion layer 20 but includes the housing 10 and the outer surface layer 30 (see Fig. 3), the hole H includes the first hole 11 of the housing 10. The first hole 11 is a through hole extending through the housing 10 in the Z-Z' direction. The outer surface layer 30 closes the first hole 11 of the housing 10 from the Z-direction side. A portion of the outer surface layer 30 that is located on the Z-direction side relative to the first hole 11 forms the bottom portion of the hole H, and the surface on the Z-direction side of the bottom portion includes the touch region.

The unit U1 is attached to the attachment target T so as to be partly accommodated, from the Z'-direction side, in the hole H of the attachment target T. The state in which the unit U1 is thus attached to the attachment target T may also be referred to simply as a "first attached state".

The unit U1 includes a detection sensor 100. The detection sensor 100 includes a first face on the Z-direction side and a second face on the Z'-direction side. The detection sensor 100 is a touch sensor, a pressure sensor, or the like, and configured to be able to detect approach of a detection target from the Z-direction side.

Where the detection sensor 100 is a capacitive touch sensor, the detection sensor 100 includes at least one sensor layer 110. The at least one sensor layer 110 may be a single sensor layer 110 or a plurality of sensor layers 110. For convenience of description, the at least one sensor layer 110 may be hereinafter referred to also as "the or each sensor layer 110". Where a single sensor layer 110 is provided, the sensor layer 110 of "the or each sensor layer 110" means the single sensor layer 110, and where a plurality of sensor layers 110 is provided, each sensor layer 110 of "the or each sensor layer 110" means each of the sensor layers 110. The or each sensor layer 110 is a plate or film of synthetic resin, such as polycarbonate (PC) resin, polymethyl methacrylate (PMMA) resin, acrylonitrile butadiene styrene (ABS) resin, polyethylene terephthalate (PET) resin, cycloolefin polymer (COP) resin, DURABIO (registered trademark) resin, or the like.

Where the at least one sensor layer 110 is the single sensor layer 110, a first face on the Z-direction side of the single sensor layer 110 is the first face of the detection sensor 100, and a second face on the Z'-direction side of the single sensor layer 110 is the second face of the detection sensor 100. Where the at least one sensor layer 110 is the plurality of sensor layers 110, the sensor layers 110 are stacked in the Z-Z' direction. The plurality of the sensor layers 110 includes an uppermost sensor layer on the most Z-direction side and a lowermost sensor layer on the most Z'-direction side. The uppermost sensor layer includes a first face on the Z-direction side and a second face on the Z'-direction side, and the first face of the uppermost sensor layer is the first face of the detection sensor 100. The lowermost sensor layer includes a first face on the Z-direction side and a second face on the Z'-direction side, and the second face of the uppermost sensor layer is the second face of the detection sensor 100.

The detection sensor 100 further includes at least one first electrode 120. The at least one first electrode 120 may be a single first electrode 120 or a plurality of first electrodes 120. For convenience of description, the at least one first electrode 120 may be hereinafter referred to also as "the or each first electrode 120" in a similar manner to the at least one sensor layer 110. The or each first electrode 120 is constituted by a transparent conductive film or a conductor. In the first attached state described above, the or each first electrode 120 is located on the Z'-direction side relative to the touch region of the attachment target T.

Where the at least one sensor layer 110 is the single sensor layer 110, the or each first electrode 120 is provided on the first or second face of the single sensor layer 110. Where the at least one sensor layer 110 is the plurality of sensor layers 110, the or each first electrode 120 is provided on the first or second face of any one of the sensor layers 110.

The or each first electrode 120 is electrically connected to a controller (not illustrated). The controller may be provided in the unit U1. Alternatively, the controller may not be provided in the unit U1but built in the automobile, furniture, the portable information terminal, the stationary information terminal, or the like described above. For convenience of description, the "controller" herein refers to either the controller of the unit U1 or the controller provided outside the unit U1.

The detection sensor 100 may further include at least one second electrode 120. The at least one second electrode 120 may be a single second electrode 120 or a plurality of second electrodes 120. For convenience of description, the at least one second electrode 120 may be hereinafter referred to also as "the or each second electrode 120" in a similar manner to the at least one sensor layer 110. The or each second electrode 120 is constituted by a transparent conductive film or a conductor. In the first attached state described above, the or each second electrode 120 is located on the Z'-direction side relative to the touch region of the attachment target T.

Where the at least one sensor layer 110 is the single sensor layer 110, the or each second electrode 120 is provided on the first or second face of the single sensor layer 110. Where the at least one sensor layer 110 is the plurality of sensor layers 110, the or each second electrode 120 is provided on the first or second face of any one of the sensor layers 110. The or each second electrode 120 is also electrically connected to the controller.

Where the detection sensor 100 is a capacitive touch sensor of a self-capacitance type, the detection sensor 100 includes the at least one first electrode 120 but not the at least one second electrode 120. In this case, the first electrode or electrodes 120 are electrically charged and discharged from the controller. During this time, a detection target touches the touch region from the Z-direction side (i.e., approaches the single first electrode 120 or at least one of the first electrodes 120, from the Z-direction side), and the touch causes a change in the electrostatic capacitance between the detection target and the single first electrode 120, or alternatively between the detection target and the at least one of the first electrodes 120. According to the change in electrostatic capacitance, there is a change in a signal (e.g., voltage or current) of the single first electrode 120 or the at least one of the first electrodes 120. The controller is configured to monitor signals of the first electrode or electrodes 120 and also compare the signals of the first electrode or electrodes 120 with a first threshold value on a memory of the controller. When the controller determines as a result of the comparison that a signal of the single first electrode 120 or the at least one of the first electrodes 120 has exceeded the first threshold value, then the controller determines that the detection target has touched a portion of the touch region that is located on the Z-direction side relative to the first electrode 120 providing a signal that has exceeded the first threshold value.

Where the detection sensor 100 is a touch sensor of a mutual-capacitance type, the detection sensor 100 includes the at least one first electrode 120 and the at least one second electrode 120. The second electrode or electrodes 120 are drive electrode or electrodes, and the first electrode or electrodes 120 are detection electrode or electrodes. A drive pulse is supplied from the controller to the second electrode or electrodes 120. During this time, a detection target approaches the single first electrode 120 or at least one of the first electrodes 120, and also the single second electrode 120 or at least one of the second electrodes 120 from the Z-direction side, and there is a change in electrostatic capacitance between the single first electrode 120, or alternatively at least one of the first electrodes 120, and the single second electrode 120, or alternatively at least one of the second electrodes 120, so that there is a change in a signal of the first electrode or electrodes 120. The controller is configured to monitor signals (voltage or current) of the first electrode or electrodes 120 and compare the signals of the first electrode or electrodes 120 with a second threshold value on a memory of the controller. When the controller determines as a result of the comparison that a signal of the single first electrode 120 or the at least one of the first electrodes 120 has exceeded the second threshold value, then the controller determines that the detection target has touched a portion of the touch region that is located on the Z-direction side relative to the first electrode 120 providing a signal that has exceeded the second threshold value.

The detection sensor 100 may be of a combined self-capacitive and mutual-capacitive type. In this case, during the time that the first electrode or electrodes 120 are electrically charged and discharged from the controller, there is a change in the electrostatic capacitance between a detection target approaching from the Z-direction side and the single first electrode 120, or alternatively between the detection target and the at least one of the first electrodes 120, so that there is a change in a signal of the single first electrode 120 or the at least one of the first electrodes 120. Also, during the time that a drive pulse is supplied from the controller to the second electrode or electrodes 120, a detection target approaches the single first electrode 120 or at least one of the first electrodes 120, and also the single second electrode 120 or at least one of the second electrodes 120 from the Z-direction side, and there is a change in electrostatic capacitance between the single first electrode 120, or alternatively at least one of the first electrodes 120, and the single second electrode 120, or alternatively at least one of the second electrodes 120, so that there is a change in a signal of the first electrode or electrodes 120. The controller is configured to monitor signals (voltage or current) of the first electrode or electrodes 120 and compare the signals of the first electrode or electrodes 120 with a third threshold value on a memory of the controller. When the controller determines as a result of the comparison that a signal of the single first electrode 120 or the at least one of the first electrodes 120 has exceeded the third threshold value, then the controller determines that the detection target has touched a portion of the touch region that is located on the Z-direction side relative to the first electrode 120 providing a signal that has exceeded the third threshold value.

Where the detection sensor 100 is a resistive touch sensor (not illustrated), the detection sensor 100 includes the at least one sensor layer 110, the at least one first electrode 120, the at least one second electrode 120, and at least one spacer having insulating properties. The at least one sensor layer 110 may include a first sensor layer 110 and a second sensor layer 110. The first sensor layer 110 includes a first face on the Z-direction side and a second face on the Z'-direction side. The second sensor layer 110 includes a first face on the Z-direction side and a second face on the Z'-direction side. The first face of the first sensor layer 110 is the first face of the detection sensor 100, and the second face of the second sensor layer 110 is the second face of the detection sensor 100. The at least one first electrode 120 is provided on the second face of the first sensor layer 110, and the at least one second electrode 120 is provided on the first face of the second sensor layer 110, in spaced relation to the at least one first electrode 120 in the Z-Z' direction. The at least one spacer is interposed, and separates, between the first sensor layer 110 and the second sensor layer 110, or alternatively between the at least one first electrode 120 and the at least one second electrode 120. A detection target approaching from the Z-direction side applies load onto part of the at least one first electrode 120, and thereby at least a part of the at least one first electrode 120 flexes and makes contact with the at least one second electrode 120, so that the at least one first electrode 120 makes electrical conduct with the at least one second electrode 120. The controller is configured to detect the electrical conduction and thereby determine that the detection target has touched a portion that is located on the Z-direction side relative to the first electrode or electrodes 120.

Where the detection sensor 100 is a pressure sensor (not illustrated), the pressure sensor is configured such that a detection target makes contact with a touch region of the attachment target T (i.e., the detection target approaches from the Z-direction side), pressure is applied onto the pressure sensor, and a signal (voltage or the like) of the pressure sensor changes. The controller monitors a signal (voltage or the like) of the pressure sensor, and compares the signal of the pressure sensor with a fourth threshold on a memory of the controller. When the controller determines as a result of the comparison that a signal of the pressure sensor exceeds the fourth threshold, then the controller determines that the detection target has touched the touch region.

It should be noted that the detection sensor 100 is not limited to a capacitive touch sensor, resistive touch sensor, a pressure sensor, or the like, but may be an ultrasonic surface acoustic wave touch sensor, an optical touch sensor, an inductive touch sensor, or the like.

The unit U1 further includes at least one cushion 200. The at least one cushion 200 may be a single cushion 200 or a plurality of cushions 200. For convenience of description, the at least one cushion 200 may be hereinafter referred to also as "the or each cushion 200" in a similar manner to the at least one sensor layer 110. The or each cushion 200 is constituted by elastic substance (e.g., the same material as that of the cushion layer 20 of the attachment target T, or other elastic substance). The or each cushion 200 may preferably, but is not required to, have insulating properties or a high resistance value (for example, a surface resistance value of the order of the 9th power of 10 Ω/□ or higher). The surface resistance value may be a value measured by a measurement method conforming to JIS K 6911, JIS C 2170, or other standards, for example. Examples of the other elastic substance include a closed-cell foam substance (e.g., general-purpose polyethylene foam, sponge rubber, or the like), an open-cell foam substance (e.g., urethane foam or the like), polyurethane, polyethylene, polypropylene, silicone, or the like. The closed-cell foam substance has a plurality of internal bubbles independent from each other. The open-cell foam substance has a plurality of internal bubbles continuously provided. Neighboring ones of the bubbles communicate with each other. The or each cushion 200 may, but is not required to, have waterproofness. The or each cushion 200 may only needs to have waterproofness satisfying the International Electrotechnical Commission rating (JIS C0920) of IPX1 or higher. In this case, the or each cushion 200 may be constituted by a closed-cell foam substance having waterproofness described above, for example.

The at least one cushion 200 covers the detection sensor 100 at least party (i.e., partly or entirely) from the Z-direction side. Where the at least one cushion 200 is the single cushion 200 (see Figs. 1A, 1B, and 4B), the single cushion 200 includes a first face on the Z-direction side and a second face on the Z'-direction side. The second face of the single cushion 200 may be in surface contact with the first face of the detection sensor 100. Alternatively, the second face of the single cushion 200 and the first face of the detection sensor 100 may be in contact with each other via an interlayer member 600 (e.g., an adhesive layer, a double-sided tape, or the like). Where the interlayer member 600 is an adhesive layer or a double-sided tape, the second face of the single cushion 200 and the first face of the detection sensor 100 are bonded together with the interlayer member 600.

Where the at least one cushion 200 is the plurality of cushions 200 (see Figs. 4A and 4C), the plurality of cushions 200 are stacked in the Z-Z' direction. The plurality of cushions 200 include an uppermost cushion 200 on the most Z-direction side and a lowermost cushion 200 on the most Z'-direction side. The uppermost cushion 200 includes a first face on the Z-direction side. The lowermost cushion 200 includes a second face on the Z'-direction side. The second face of the lowermost cushion 200 is in surface contact with the first face of the detection sensor 100, or alternatively is in contact with or bonded to the first face of the detection sensor 100 via an interlayer member 600, in a similar manner to the single cushion 200. The Z-Z' direction is a direction along which the at least one cushion 200 and the detection sensor 100 are arranged.

The plurality of cushions 200 includes at least one set of two cushions 200 adjacent to each other in the Z-Z' direction. Of the two cushions 200 adjacent to each other, the cushion 200 on the Z-direction side may be hereinafter referred to also as a first cushion 200a, and the cushion 200 on the Z'-direction side may be hereinafter referred to also as a second cushion 200b. The first cushion 200a and the second cushion 200b may be in surface contact with each other or may be in contact with each other via an interlayer member 600. Where the interlayer member 600 is an adhesive layer or a double-sided tape, the first cushion 200a and the second cushion 200b are bonded together with the interlayer member 600. Where the plurality of cushions 200 is two cushions 200, the first cushion 200a is the uppermost cushion 200, and the second cushion 200b is the lowermost cushion 200. Where the plurality of cushions 200 is three or more cushions 200, the first cushion 200a is the uppermost cushion 200, and the second cushion 200b is a cushion 200 that is located on the Z'-direction side relative to the uppermost cushion 200, or alternatively the second cushion 200b is the lowermost cushion 200, and the first cushion 200a is a cushion 200 located on the Z-direction side relative to the lowermost cushion 200, or alternatively the first cushion 200a and the second cushion 200b are cushions 200 between the uppermost cushion and the lowermost cushion 200.

Where the cushion or cushions 200 cover the detection sensor 100 partly, the cushion 200 or cushions 200 may have any outer shape as viewed from the Z-direction side, and have outer dimensions (projected area) as viewed from the Z-direction side that are smaller than those of the detection sensor 100. Where the cushion or cushions 200 cover the detection sensor 100 entirely, the cushion 200 or cushions 200 may have an outer shape as viewed from the Z-direction side that is substantially identical to that of the detection sensor 100, and have outer dimensions (projected area) as viewed from the Z-direction side that are substantially identical to those of the detection sensor 100; or alternatively the cushion 200 or cushions 200 may have any outer shape as viewed from the Z-direction side, and have outer dimensions (projected area) as viewed from the Z-direction side that are larger than those of the detection sensor 100.

The unit U1 may further include at least one exhaust path P. The at least one exhaust path P may be provided in at least one face of the second face of the single cushion 200 or the first face of the detection sensor 100, or alternatively at least one face of the second face of the lowermost cushion 200 or the first face of the detection sensor 100. The at least one exhaust path P may open out to the at least one face and open out to a side face or faces that meet the at least one face. For example, the at least one exhaust path P may be a through hole or holes (not illustrated) or groove or grooves (see Fig. 4B), which extend along the at least one face, open out to the at least one face (at least one of the Z and Z' directions), and open out to a side face or faces that meet the at least one face. Where the detection sensor 100 is subjected to surface treatment such as overcoating (this will be referred to as a surface-treated portion), the surface-treated portion of the detection sensor 100 includes the first face of the detection sensor 100. In this case, the at least one exhaust path P may be a through hole or holes or a groove or grooves provided in the first face of the surface-treated portion of the detection sensor 100.

Alternatively, where the single cushion 200 (not illustrated) or the lowermost cushion 200 (see Figs. 4A and 4C) is constituted by the open-cell foam substance described above, the at least one exhaust path P may be constituted by a plurality of bubbles of the single cushion 200 or lowermost cushion 200. The at least one exhaust path P includes at least one first bubble, at least one second bubble, and at least one third bubble. The at least one first bubble is provided in, and opens out to, the second face of the single cushion 200 or lowermost cushion 200. The at least one second bubble is provided in, and opens out to, a side face of the single cushion 200 or lowermost cushion 200. Where the at least one first bubble and the at least one second bubble are each a single bubble and the at least one third bubble is a single or plurality of bubbles, the first bubble and the second bubble are connected by, and communicate with each other through, the third bubble or bubbles. In this case, the at least one exhaust path P is a single exhaust path P including the single first bubble, the single second bubble, and the single or plurality of third bubbles. Where the at least one first bubble, the at least one second bubble, and the at least one third bubble are each a plurality of bubbles, each of the first bubbles and each of the second bubbles are connected by, and communicate with each other through, at least one third bubble (a single or plurality of third bubble) of the plurality of third bubbles (of all the third bubbles). In this case, there is provided a plurality of exhaust paths P, each of which includes one of the first bubbles, one of the second bubbles, and the at least one third bubble (the single or plurality third bubble) of the third bubbles (of all the third bubbles).

Where the interlayer member 600 is interposed between the second face of the single cushion 200 or lowermost cushion 200 and the first face of the detection sensor 100, the at least one exhaust path P may be a through hole or holes or a groove or grooves provided in the interlayer member 600, which open out toward the at least one face of the second face of the single cushion 200 or the first face of the detection sensor 100, or alternatively toward at least one face of the second face of the lowermost cushion 200 or the first face of the detection sensor 100, and open out to a side face of the interlayer member 600. Even if the interlayer member 600 is provided, the at least one exhaust path P may be provided in other than the interlayer member 600 described above.

The at least one exhaust path P described above may be provided as a plurality of exhaust paths P. The at least one exhaust path P may be omitted. Irrespective of whether the at least one exhaust path P is provided (except a case where the at least one exhaust path P includes the plurality of bubbles), a cushion 200 located on the Z-direction side relative to the lowermost cushion 200 may have waterproofness as described above. For example, the first cushion 200a may be constituted by a closed-cell foam substance having waterproofness.

The unit U1 may further include a cover 500 (see Figs. 4B and 4C). The cover 500 is made of a similar material as the outer surface layer 30. The cover 500 and the outer surface layer 30 may be made of the same material or different materials. The cover 500 has an outer shape as viewed from the Z-direction side that is substantially identical to that of the at least one cushion 200, and also have outer dimensions (projected area) as viewed from the Z-direction side that are substantially identical to those of the at least one cushion 200. The cover 500 covers the at least one cushion 200 and the detection sensor 100 from the Z-direction side.

The cover 500 includes a first face on the Z-direction side and a second face on the Z'-direction side. Where the at least one cushion 200 is the single cushion 200, the second face of the cover 500 may be in surface contact with the first face of the single cushion 200. Alternatively, the second face of the cover 500 may be in contact with the second face of the single cushion 200 via an interlayer member 600 (not illustrated). Where the interlayer member 600 is an adhesive layer or a double-sided tape, the second face of the cover 500 and the second face of the single cushion 200 are bonded together with the interlayer member 600. Where the at least one cushion 200 is the plurality of cushions 200, the second face of the cover 500 may be in surface contact with the first face of the uppermost cushion 200 of the plurality of cushions 200. Alternatively, the second face of the cover 500 may be in contact with the second face of the uppermost cushion 200 via an interlayer member 600 (not illustrated). Where the interlayer member 600 is an adhesive layer or a double-sided tape, the second face of the cover 500 and the second face of the uppermost cushion 200 are bonded together with the interlayer member 600. The cover 500 may be omitted.

The unit U1 further includes a body 300. The body 300 is made of an insulating material (e.g., insulating resin). The body 300 includes a holder 310. The holder 310 is located on the Z'-direction side relative to the detection sensor 100 and supports the detection sensor 100. For example, the holder 310 may be constituted by a plate extending in a direction substantially orthogonal to the Z-Z' direction (this direction will be hereinafter referred to as "the orthogonal direction") or by a central portion of the plate. In this case, the configuration may be such that the second face of the detection sensor 100 is in surface contact with, or alternatively bonded with an adhesive layer, a double-sided tape, or the like (not illustrated) to, a face on the Z-direction side of the holder 310. Alternatively, the holder 310 may be constituted by a box including a bottom portion and a side wall extending in the Z direction from a periphery of the bottom portion and opening out in the Z direction, or alternatively constituted by the bottom portion of the box. In this case, the configuration may be such that the second face of the detection sensor 100 is in surface contact with, or alternatively bonded with an adhesive layer, a double-sided tape, or the like (not illustrated) to, the face on the Z-direction side of the bottom portion of the holder 310.

The body 300 may further include at least one fixable portion 320. The at least one fixable portion 320 may be a single fixable portion 320 or a plurality of fixable portions 320. For convenience of description, the at least one fixable portion 320 may be hereinafter referred to also as "the or each fixable portion 320" in a similar manner to the at least one sensor layer 110. The or each fixable portion 320 is located outside the detection sensor 100 supported by the holder 310 in the orthogonal direction. For example, where the holder 310 is constituted by the plate or the box, the or each fixable portion 320 may be constituted by an arm or flange extending from the holder 310 in the orthogonal direction. Where the holder 310 is configured by the center portion of a plate, one of each of the fixable portions 320 may be constituted by an edge portion around the center portion of the plate. Where the holder 310 is constituted by the bottom portion of the box, one of each of the fixable portions 320 may be constituted by the side wall of the box. In the first attached state, the or each fixable portion 320 of any of these configurations is located on the Z'-direction side relative to a periphery of the first hole 11 of the housing 10 of the attachment target T and fixed to the periphery of the first hole 11 of the housing 10 by screwing, bonding, welding, or other means.

The or each fixable portion 320 includes an attachable face on the Z-direction side, which is in direct or indirect contact with the periphery of the first hole 11 of the housing 10 of the attachment target T. Where the cover 500 is not provided, a "first height position" will hereinafter refer to a height position in the Z-Z' direction of the attachable face of the or each fixable portion 320 relative to the detection sensor 100 and the at least one cushion 200. Where the cover 500 is provided, a "second height position" will hereinafter refer to a height position in the Z-Z' direction of the attachable face of the or each fixable portion 320 relative to the detection sensor 100, the at least one cushion 200, and the cover 500. The first or second height position of the attachable face of the or each fixable portion 320 may be set as desired by increasing a thickness dimension of the or each fixable portion 320 in the Z-Z' direction or by configuring the or each fixable portion 320 to extend in the Z-Z' direction. For example, the first or second height position of the attachable face of the or each fixable portion 320 may be set to be a height position (a) substantially the same as a height position in the Z-Z' direction of the second face of the detection sensor 100 (see Figs. 1A to 2 and 4A to 4C), a height position (b) substantially the same as a height position in the Z-Z' direction of the first face of the detection sensor 100, the second face of the single cushion 200, or the second face of the lowermost cushion 200 (not illustrated), or a height position (c) substantially the same as a height position in the Z-Z' direction between the first face and the second face of the single cushion 200 or between the first face of the uppermost cushion 200 and the first face of the lowermost cushion 200 (not illustrated). Further, the second height position of the attachable face of the or each fixable portion 320 may be set to be a height position (d) substantially the same as a height position in the Z-Z' direction of the first face of the single cushion 200, the first face of the uppermost cushion 200, or the second face of the cover 500 (not illustrated).

Where the first height position of the attachable face of the or each fixable portion 320 is the height position (a) described above and no interlayer member 600 are provided on the Z-direction side relative to the attachable face, a part of the unit U1 that is located on the Z-direction side relative to the attachable face of the or each fixable portion 320 (i.e., the detection sensor 100 and the cushion or cushions 200) serves as a first accommodatable part (see Figs. 1A to 2 and 4A). Where the first height position of the attachable face of the or each fixable portion 320 is the height position (a) described above and the interlayer member or members 600 are provided on the Z-direction side relative to the attachable face, the first accommodatable part includes the interlayer member or members 600, in addition to the detection sensor 100 and the cushion or cushions 200. Where the second height position of the attachable face of the or each fixable portion 320 is the height position (a) described above and no interlayer member 600 are provided on the Z-direction side relative to the attachable face, a part of the unit U1 that is located on the Z-direction side relative to the attachable face of the or each fixable portion 320 (i.e., the detection sensor 100, the cushion or cushions 200, and the cover 500) serves as a second accommodatable part (see Figs. 4B and 4C). Where the second height position of the attachable face of the or each fixable portion 320 is the height position (a) described above and the interlayer member or members 600 are provided on the Z-direction side relative to the attachable face, the second accommodatable part includes the interlayer member or members 600, in addition to the detection sensor 100, the cushion or cushions 200, and the cover 500.

Where the first height position of the attachable face of the or each fixable portion 320 is the height position (b) described above and no interlayer member 600 are provided on the Z-direction side relative to the attachable face, a part of the unit U1 that is located on the Z-direction side relative to the attachable face of the or each fixable portion 320 (i.e., the cushion or cushions 200) serves as a third accommodatable part. Where the first height position of the attachable face of the or each fixable portion 320 is the height position (b) described above and the interlayer member or members 600 are provided on the Z-direction side relative to the attachable face, the third accommodatable part includes the interlayer member or members 600, in addition to the cushion or cushions 200. Where the second height position of the attachable face of the or each fixable portion 320 is the height position (b) described above and no interlayer member 600 are provided on the Z-direction side relative to the attachable face, a part of the unit U1 that is located on the Z-direction side relative to the attachable face of the or each fixable portion 320 (i.e., the cushion or cushions 200 and the cover 500) serves as a fourth accommodatable part. Where the second height position of the attachable face of the or each fixable portion 320 is the height position (b) described above and the interlayer member or members 600 are provided on the Z-direction side relative to the attachable face, the fourth accommodatable part includes the interlayer member or members 600, in addition to the cushion or cushions 200 and the cover 500.

Where the first height position of the attachable face of the or each fixable portion 320 is the height position (c) described above and no interlayer member 600 are provided on the Z-direction side relative to the attachable face, a part of the unit U1 that is located on the Z-direction side relative to the attachable face of the or each fixable portion 320 (i.e., a part of the cushion 200 or cushion set (cushions 200) that is located on the Z-direction side relative to the or each fixable portion 320) serves as a fifth accommodatable part. Where the first height position of the attachable face of the or each fixable portion 320 is the height position (c) described above and the interlayer member or members 600 are provided on the Z-direction side relative to the attachable face, the fifth accommodatable part includes the interlayer member or members 600, in addition to the part of the cushion 200 or cushion set (cushions 200) that is located on the Z-direction side relative to the or each fixable portion 320. Where the second height position of the attachable face of the or each fixable portion 320 is the height position (c) described above and no interlayer member 600 are provided on the Z-direction side relative to the attachable face, a part of the unit U1 that is located on the Z-direction side relative to the attachable face of the or each fixable portion 320 (i.e., a part of the cushion 200 or cushion set (cushions 200) that is located on the Z-direction side relative to the or each fixable portion 320, and the cover 500) serves as a sixth accommodatable part. Where the second height position of the attachable face of the or each fixable portion 320 is the height position (c) described above and the interlayer member or members 600 are provided on the Z-direction side relative to the attachable face, the sixth accommodatable part includes the interlayer member or members 600, in addition to the part of the cushion 200 or cushion set (cushions 200) that is located on the Z-direction side relative to the or each fixable portion 320 and the cover 500.

Where the second height position of the attachable face of the or each fixable portion 320 is the height position (d) described above and no interlayer member 600 are provided on the Z-direction side relative to the attachable face, a part of the unit U1 that is located on the Z-direction side relative to the attachable face of the or each fixable portion 320 (i.e., the cover 500) serves as a seventh accommodatable part. Where the second height position of the attachable face of the or each fixable portion 320 is the height position (d) described above and the interlayer member or members 600 are provided on the Z-direction side relative to the attachable face, the seventh accommodatable part includes the interlayer member or members 600, in addition to the cover 500.

Where the attachable face of the or each fixable portion 320 is in direct contact with the periphery of the first hole 11 of the housing 10 of the attachment target T, the first, second, third, fourth, fifth, sixth, or seventh accommodatable part of the unit U1 has a dimension in the Z-Z' direction that is substantially identical to that of the hole H of the attachment target T. Where the attachable face of the or each fixable portion 320 is in indirect contact with the periphery of the first hole 11 of the housing 10 of the attachment target T via another member, such as an elastic body, the sum of dimensions in the Z-Z' direction of the first, second, third, fourth, fifth, sixth, or seventh accommodatable part and the another member is substantially identical to the dimension in the Z-Z' direction of the hole H of the attachment target T. Further, the first, second, third, fourth, fifth, sixth, or seventh accommodatable part of the unit U1 further includes a configuration (A) or (B) below.
(A) The first, second, third, fourth, fifth, sixth, or seventh accommodatable part as viewed from the Z-direction side has an outer shape that is substantially identical to that of the hole H, and also has outer dimensions (projected area) as viewed from the Z-direction side that are substantially identical to those of the hole H. In the first attached state, the first, second, third, fourth, fifth, sixth, or seventh accommodatable part fits in the hole H of the attachment target T (see Fig. 1A). In this fitted state, a face on the most Z-direction side of the first, second, third, fourth, fifth, sixth, or seventh accommodatable part (the first face of the single cushion 200, the first face of the uppermost cushion 200, or the first face of the cover 500) of the unit U1 abuts a face on the Z'-direction side of the bottom portion of the hole H.
(B) The first, second, third, fourth, fifth, sixth, or seventh accommodatable part as viewed from the Z-direction side has an outer shape that is substantially identical to, or different from, that of the hole H, and has outer dimensions (projected area) as viewed from the Z-direction side that are smaller than those of the hole H. In the first attached state, the first, second, third, fourth, fifth, sixth, or seventh accommodatable part is accommodated in the hole H of the attachment target T (see Fig. 1A). In this accommodated state, a face on the most Z-direction side of the first, second, third, fourth, fifth, sixth, or seventh accommodatable part (the first face of the single cushion 200, the first face of the uppermost cushion 200, or the first face of the cover 500) of the unit U1 abuts the face on the Z'-direction side of the bottom portion of the hole H.

Noted that the outer surface layer 30 constituting the bottom portion of the hole H, or alternatively the bottom portion 21a and the outer surface layer 30 constituting the bottom portion of the hole H, have flexibility. Therefore, when the touch region of the bottom portion of the hole H is touched by a detection target, the bottom portion flexes so as to elastically deform the at least one cushion 200 of the first, second, third, fourth, fifth, sixth, or seventh accommodatable part.

In a state where the third or fourth accommodatable part is fitted or accommodated in the hole H as described above, the detection sensor 100 in its entirety is located on the Z'-direction side relative to the hole H. In a state where the fifth or sixth accommodatable part is fitted or accommodated in the hole H as described above, the detection sensor 100 in its entirety and a part of the cushion 200 or cushion set (cushions 200) that is located on the Z'-direction side relative to the attachable face are located on the Z'-direction side relative to the hole H. In a state where the seventh accommodatable part is fitted or accommodated in the hole H as described above, the detection sensor 100 in its entirety and the cushion 200 or cushion set (cushions 200) in its entirety are located on the Z'-direction side relative to the hole H.

Where the holder 310 is constituted by the box including the bottom portion and the side wall, an accommodation hole defined by the bottom portion and the side wall of the holder 310 (which may be hereinafter referred to also as the accommodation hole of the box) may accommodate one of the following: the detection sensor 100 located on the Z'-direction side relative to the third or fourth accommodatable part; the detection sensor 100 and the part of the cushion 200 or cushion set (cushions 200) located on the Z'-direction side relative to the fifth or sixth accommodatable part; or the detection sensor 100 and the cushion or cushions 200 located on the Z'-direction side relative to the seventh accommodatable part. The part of the cushion 200 or cushion set (cushions 200) is located on the Z'-direction side relative to the attachable face.

Alternatively, where the holder 310 is constituted by the box, and the first, second, third, fourth, fifth, sixth, or seventh accommodatable part includes configuration (B) above, at least a portion on the Z'-direction side of the first or second accommodatable part (the portion on the Z'-direction side of the first or second accommodatable part, or alternatively the first or second accommodatable part in its entirety) may be accommodated in the accommodation hole of the box of the holder 310; at least a portion on the Z'-direction side of the third or fourth accommodatable part (the portion on the Z'-direction side of the third or fourth accommodatable part, or alternatively the third or fourth accommodatable part in its entirety) may be accommodated in the accommodation hole of the box of the holder 310, and the detection sensor 100 located on the Z'-direction side relative to the third or fourth accommodatable part may be accommodated in the accommodation hole of the box of the holder 310; at least a portion on the Z'-direction side of the fifth or sixth accommodatable part (the portion on the Z'-direction side of the fifth or sixth accommodatable part, or alternatively the fifth or sixth accommodatable part in its entirety) may be accommodated in the accommodation hole of the box of the holder 310, and the detection sensor 100 and the part of the cushion 200 or cushion set (cushions 200) located on the Z'-direction side relative to the fifth or sixth accommodatable part may be accommodated in the accommodation hole of the box of the holder 310; at least a portion on the Z'-direction side of the seventh accommodatable part (the portion on the Z'-direction side of the seventh accommodatable part, or alternatively the seventh accommodatable part in its entirety) may be accommodated in the accommodation hole of the box of the holder 310, and the detection sensor 100 and the cushion or cushions 200 located on the Z'-direction side relative to the seventh accommodatable part may be accommodated in the accommodation hole of the box of the holder 310. The part of the cushion 200 or cushion set (cushions 200) is located on the Z'-direction side relative to the attachable face. In this case, the side wall of the holder 310 may have a dimension in the Z-Z' direction that is substantially identical to, or smaller than, that of the hole H of the attachment target T, and the holder 310 may have an outer shape as viewed from the Z-direction side may be identical to the shape of the hole H viewed from the Z-direction side, and the holder 310 may have outer dimensions (projected area) as viewed from the Z-direction side may be substantially identical to dimensions (projected area) of the hole H as viewed from the Z-direction side. In this case, the holder 310 may preferably, but is not required to, fit in the hole H of the attachment target T in the first attached state.

Note that the at least one fixable portion 230 may be omitted. In this case, the unit U1 may further include an attachment member (not illustrated), for example. The attachment member generally has an inverted Ω-shape (a shape of a Japanese character " 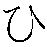 ") in a cross-sectional view in the Z-Z' direction, and includes a first portion and at least one second portion. The first portion forms a bottom portion of the generally inverted Ω-shape, and is fixed to the body 300 from the Z'-direction side, directly or indirectly via an elastic body or the like. Where the at least one second portion is a single second portion, the single second portion includes a tubular portion, which extends in the Z direction from a periphery of the first portion, and a flange, which extends outward from an edge on the Z-direction side of the tubular portion. The flange is fixable from the Z'-direction side to the periphery of the first hole 11 of the housing 10 of the attachment target T. Where the at least one second portion is a plurality of second portions, the second portions are beams generally having an L-shape inverted in cross-sectional view in the Z-Z' direction and extending in the Z direction from a periphery of the first portion, and are fixable to the periphery of the first hole 11 of the housing 10 of the attachment target T in a similar manner to the fixable portion 230. Alternatively, where the first, second, third, fourth, fifth, sixth, or seventh accommodatable part includes configuration (A) above, the unit U1 may be attached to the attachment target T by bonding the first, second, third, fourth, fifth, sixth, or seventh accommodatable part to a bottom surface on the Z'-direction side of the bottom portion of the hole H of the attachment target T and/or to a wall surface of a side wall surrounding the hole H, and/or by fitting into the hole H of the attachment target T. Where the first, second, third, fourth, fifth, sixth, or seventh accommodatable part includes configuration (B) above, the unit U1 may be attached to the attachment target T by bonding the first, second, third, fourth, fifth, sixth, or seventh accommodatable part to the bottom surface on the Z'-direction side of the bottom portion of the hole H of the attachment target T. Where the first, second, third, fourth, fifth, sixth, or seventh accommodatable part includes configuration (B) described above and the holder 310 fits in the hole H of the attachment target T, the unit U1 may be attached to the attachment target T by fitting the holder 310 into the hole H of the attachment target T and/or by bonding the holder 310 to the wall surface of the side wall surrounding the hole H of the attachment target T.

Where the cover 500 is not provided, the accommodatable part of any of the above aspects of the unit U1 may be modified in any manner as long as the at least one cushion 200 of the accommodatable part is accommodated at least partly in the hole H of the attachment target T. Where the cover 500 is provided, the accommodatable part of any of the above aspects of the unit U1 may be modified in any manner as long as at least one of the cover 500 or the at least one cushion 200 of the accommodatable part is accommodated at least partly in the hole H of the attachment target T.

The unit U1 may further include an external connection part 400. The external connection part 400 may be provided integrally with, or separately from, the detection sensor 100. In the former case, the external connection part 400 includes a led-out portion, which is contiguous with, and extended from, the at least one sensor layer 110 of the detection sensor 100, and a conductive line, which is provided on the led-out portion and connected to the at least one first electrode 120 or to the at least one first electrode 120 and the at least one second electrode 120 of the detection sensor 100. In the latter case, the external connection part 400 is constituted by a flexible substrate or the like connected to the detection sensor 100. In either case, the configuration in the first attached state may be such that the external connection part 400 is led out in the Z' direction from the detection sensor 100 and through between the body 300 and the wall of the hole H of the attachment target T, or such that the external connection part 400 is led out in the Z' direction from the detection sensor 100 and through the body 300. Where the controller is provided outside the unit U1, the external connection part 400 is electrically connected to the controller or other element outside the unit U1. Note that the external connection part 400 may be omitted. In this case, the body 300 may be provided with an opening for exposing a part of the detection sensor 100 so as to allow the detection sensor 100 to be connected through the opening to the controller and other element outside the unit U1. Alternatively, where the controller is provided in the unit U1, the detection sensor 100 and the controller may be electrically connected together via the external connection part 400, or via other connection means where the external connection part 400 is omitted.

The attachment structure and the unit U1 described above provide technical features and effects below.

### First technical feature and effect

It is easy to attach the unit U1 to the attachment target T. This is because the at least one cushion 200 is provided on the first face of the detection sensor 100 of the unit U1, obviating the need to bond the cushion to the unit U1 when attaching the unit U1 to the attachment target T.

### Second technical feature and effect

When the touch region of the attachment target T is touched by a detection target, the at least one cushion 200 on the first face of the detection sensor 100 of the unit U1 elastically deform. This improves an operating feel when operating the unit U1.

### Third technical feature and effect

Where the detection sensor 100 is a capacitive touch sensor, in a state where the unit U1 is attached to the attachment target T, variation in sensitivity occurring in the detection sensor 100 is suppressed for the following reasons. Where the capacitive detection sensor is arranged between a housing and a cushion layer as in the conventional example, the material and/or the dimension in the Z-Z' direction of the cushion layer are unknown when fabricating the detection sensor. For this reason, when the detection sensor is arranged between the housing and the cushion layer, a dielectric constant around the detection sensor changes depending on the material and/or the dimension in the Z-Z' direction of the cushion layer. This causes variation in sensitivity of the detection sensor. In contrast, the at least one cushion 200 is provided on the first face of the detection sensor 100 of the unit U1, it is possible to approximate in advance a dielectric constant around the detection sensor 100 according to the material and/or the dimension in the Z-Z' direction of the at least one cushion 200, and accordingly set the sensitivity of the detection sensor 100. It is also possible to select the material and/or the dimension in the Z-Z' direction of the at least one cushion 200 according to sensitivity of the detection sensor 100.

### Fourth technical feature and effect

Where the cover 500 is not provided, it is possible to set the height position in the Z-Z' direction of the detection sensor 100 as desired by changing the dimension in the Z-Z' direction of the cushion or cushions 200 of the unit U1. Where the cover 500 is provided, it is possible to set the height position of the detection sensor 100 in the Z-Z' direction as desired by changing the sum of the dimensions in the Z-Z' direction of the cushion or cushions 200 and the cover 500 of the unit U1.

### Fifth technical feature and effect

Where the at least one cushion 200 has waterproofness, the unit U1 has improved waterproofness. This is because the at least one cushion 200 covers the detection sensor 100 from the Z-direction side and thereby blocks liquid, such as water or sweat, coming from the Z-direction side, reducing the possibility that the liquid adhere to the detection sensor 100.

### Sixth technical feature and effect

Where the at least one exhaust path P is provided, when bringing the second face of the single cushion 200 or the second face of the lowermost cushion 200 of the plurality of cushions 200 into surface contact with the first face of the detection sensor 100, air sandwiched between the second face of the single cushion 200 or lowermost cushion 200 and the first face of the detection sensor 100 will be discharged through the at least one exhaust path P to the outside. This reduces the possibility that air is kept sandwiched between the second face of the single cushion 200 or lowermost cushion 200 and the first face of the detection sensor 100.

### Seventh technical feature and effect

Where the external connection part 400 is provided, in the first attached state, the external connection part 400 is led out in the Z' direction from the detection sensor 100 and through between the body 300 and the wall of the hole H of the attachment target T, or alternatively the external connection part 400 is led out in the Z' direction from the detection sensor 100 and through the body 300. This facilitates external connection of the detection sensor 100.

### Second embodiment

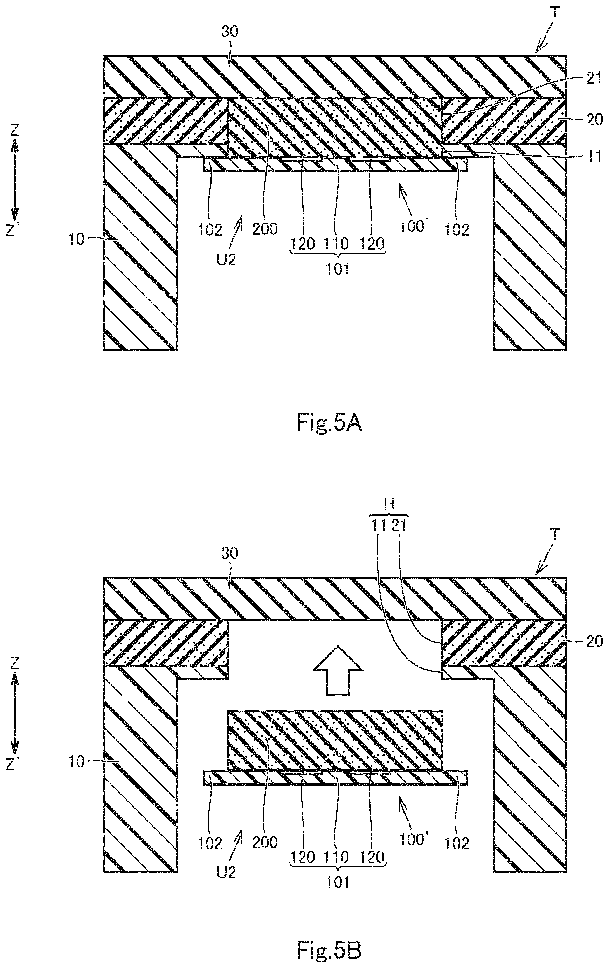

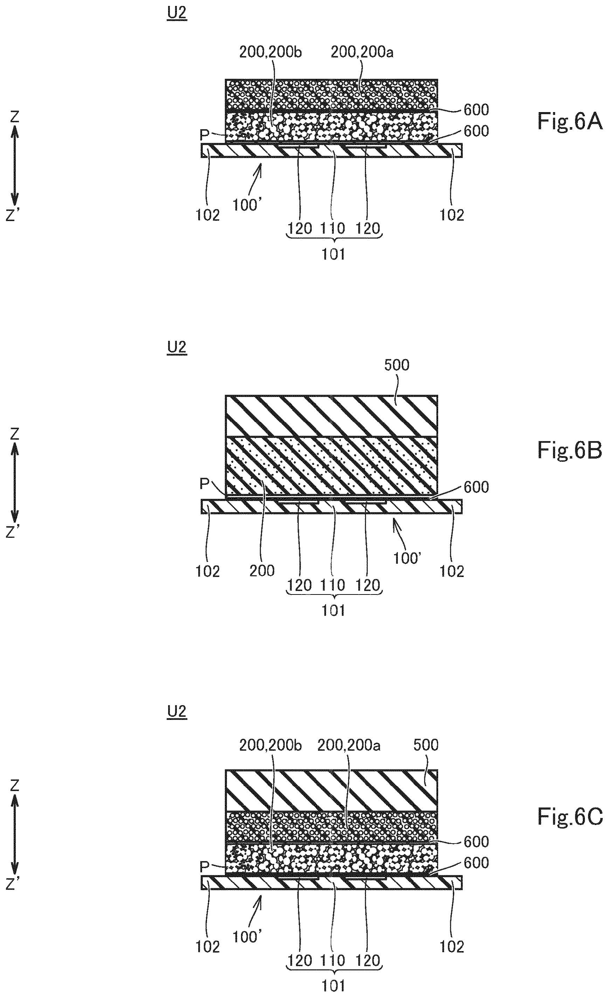

An attachment structure of a sensor unit U2 (which may be referred to simply as "unit U2") and an attachment target T according to a second embodiment of the invention and modification examples thereof of the second embodiment will be hereinafter described with reference to Figs. 5A to 6C. Figs. 5A and 5B illustrate an attachment structure of the second embodiment. Fig. 6A illustrates a first variant of the unit U2 of the attachment structure of the second embodiment, Fig. 6B illustrates a second variant of the unit U2 of the attachment structure of the second embodiment, and Fig. 6C illustrates a third variant of the unit U2 of the attachment structure of the second embodiment. Figs. 5A, 5B, and 6A to 6C also show the Z-Z' direction, similarly to the attachment structure of the first embodiment and its modification examples.

The attachment target T is as described for the first embodiment and its modification examples (see Figs. 5A, 5B, and 3A to 3B).

The unit U2 is attached to the attachment target T so as to be partly accommodated, from the Z'-direction side, in the hole H of the attachment target T. The state in which the unit U2 is thus attached to the attachment target T may also be referred to simply as a "second attached state".

The unit U2 includes the same configuration as the unit U1, except that the unit U2 is different from the unit U1 in that the body 300 is not provided and that the unit U2 includes a detection sensor 100' including a configuration that is different from that of the detection sensor 100 of the unit U1. The unit U2 will now be described focusing on the differences from the unit U1 and omitting overlapping descriptions.

The detection sensor 100' of the unit U2 includes a sensor body 101. The sensor body 101 includes a configuration similar to any configuration of the detection sensor 100 of the unit U1. The sensor body 101 includes a first face on the Z-direction side and a second face on the Z'-direction side. The first face of the sensor body 101 may be the same as the first face of the detection sensor 100 of the unit U1 of any aspect. The first face of the sensor body 101 is in surface contact with the second face of the single cushion 200 or the second face of the lowermost cushion 200 of the plurality of cushions 200. Alternatively, the first face of the sensor body 101 is in contact with, or bonded to, the second face of the single cushion 200 or the second face of the lowermost cushion 200 via the interlayer member 600. The second face of the sensor body 101 may be the same as the second face of the detection sensor 100 of the unit U1 of any aspect.

The sensor body 101 of the detection sensor 100' is covered at least party (i.e., partly or entirely) by the at least one cushion 200. Where the cushion or cushions 200 cover the sensor body 101 partly, the cushion or cushions 200 may have any outer shape as viewed from the Z-direction side, and have outer dimensions (projected area) as viewed from the Z-direction side that are smaller than those of the sensor body 101. Where the cushion or cushions 200 cover the sensor body 101 entirely, the cushion or cushions 200 may have an outer shape as viewed from the Z-direction side that is substantially identical to that of the sensor body 101, and have outer dimensions (projected area) as viewed from the Z-direction side that are substantially identical to those of the sensor body 101. The Z-Z' direction is a direction along which the at least one cushion 200 and the detection sensor 100' are arranged.

The detection sensor 100' may further include at least one fixable portion 102. The at least one fixable portion 102 may be a single fixable portion 102 or a plurality of fixable portions 102. For convenience of description, the at least one fixable portion 102 may be hereinafter referred to also as "the or each fixable portion 102" in a similar manner to the at least one sensor layer 110. The or each fixable portion 102 is located outside the sensor body 101 in a direction substantially orthogonal to the Z-Z' direction (this direction will be hereinafter referred to as "the orthogonal direction"). The or each fixable portion 102 may be constituted by an arm or flange (not illustrated) extending from the sensor body 101 in the orthogonal direction. Alternatively, the single fixable portion 102 may be constituted by a periphery (see Figs. 5A to 6C) of the sensor body 101. In the second attached state, the or each fixable portion 102 of any of these configurations is located on the Z'-direction side relative to the periphery of the first hole 11 of the housing 10 of the attachment target T and fixed to the periphery of the first hole 11 of the housing 10 by screwing, bonding, welding, or other means.

The or each fixable portion 102 includes an attachable face on the Z-direction side, which is in direct or indirect contact with the periphery of the first hole 11 of the housing 10 of the attachment target T. Where the cover 500 is not provided, a "third height position" will hereinafter refer to a height position in the Z-Z' direction of the attachable face of the or each fixable portion 102 relative to the at least one cushion 200. Where the cover 500 is provided, a "fourth height position" will hereinafter refer to a height position in the Z-Z' direction of the attachable face of the or each fixable portion 102 relative to the at least one cushion 200 and the cover 500. The third or fourth height position of the attachable face of the or each fixable portion 102 may be set as desired by increasing a thickness dimension of the or each fixable portion 102 in the Z-Z' direction or by configuring the or each fixable portion 102 to extend in the Z-Z' direction. For example, the third or fourth height position of the attachable face of the or each fixable portion 102 may be set to be a height position (e) substantially the same as a height position in the Z-Z' direction of the first face of the sensor body 101, the second face of the single cushion 200, or the second face of the lowermost cushion 200 (see Figs. 5A to 6C), or a height position (f) being a height position in the Z-Z' direction between the first face and the second face of the single cushion 200 or between the first face of the uppermost cushion 200 and the first face of the lowermost cushion 200 (not illustrated). Further, the fourth height position of the attachable face of the or each fixable portion 102 may be set to be a height position (g) substantially the same as a height position in the Z-Z' direction of the first face of the single cushion 200, the first face of the uppermost cushion 200, or the second face of the cover 500 (not illustrated).

Where the third height position of the attachable face of the or each fixable portion 102 is the height position (e) described above and no interlayer member 600 are provided on the Z-direction side relative to the attachable face, a part of the unit U2 that is located on the Z-direction side relative to the attachable face of the or each fixable portion 102 (i.e., the cushion or cushions 200) serves as a first accommodatable part. Where the third height position of the attachable face of the or each fixable portion 102 is the height position (e) described above and the interlayer member or members 600 are provided on the Z-direction side relative to the attachable face, the first accommodatable part includes the interlayer member or members 600, in addition to the cushion or cushions 200. Where the fourth height position of the attachable face of the or each fixable portion 102 is the height position (e) described above and no interlayer member 600 are provided on the Z-direction side relative to the attachable face, a part of the unit U2 that is located on the Z-direction side relative to the attachable face of the or each fixable portion 102 (i.e., the cushion or cushions 200 and the cover 500) serves as a second accommodatable part. Where the fourth height position of the attachable face of the or each fixable portion 102 is the height position (e) described above and the interlayer member or members 600 are provided on the Z-direction side relative to the attachable face, the second accommodatable part includes the interlayer member or members 600, in addition to the cushion or cushions 200 and the cover 500.

Where the third height position of the attachable face of the or each fixable portion 102 is the height position (f) described above and no interlayer member 600 are provided on the Z-direction side relative to the attachable face, a part of the unit U2 that is located on the Z-direction side relative to the attachable face of the or each fixable portion 102 (i.e., a part of the cushion 200 or cushion set (cushions 200) that is located on the Z-direction side relative to the attachable face) serves as a third accommodatable part. Where the third height position of the attachable face of the or each fixable portion 102 is the height position (f) described above and the interlayer member or members 600 are provided on the Z-direction side relative to the attachable face, the third accommodatable part includes the interlayer member or members 600, in addition to the part of the cushion 200 or cushion set (cushions 200) that is located on the Z-direction side relative to the attachable face. Where the fourth height position of the attachable face of the or each fixable portion 102 is the height position (f) described above and no interlayer member 600 are provided on the Z-direction side relative to the attachable face, a part of the unit U2 that is located on the Z-direction side relative to the attachable face of the or each fixable portion 102 (i.e., a part of the cushion 200 or cushion set (cushions 200) that is located on the Z-direction side relative to the attachable face, and the cover 500) serves as a fourth accommodatable part. Where the fourth height position of the attachable face of the or each fixable portion 102 is the height position (f) described above and the interlayer member or members 600 are provided on the Z-direction side relative to the attachable face, the fourth accommodatable part includes the interlayer member or members 600, in addition to the part of the cushion 200 or cushion set (cushions 200) that is located on the Z-direction side relative to the attachable face and the cover 500.

Where the fourth height position of the attachable face of the or each fixable portion 102 is the height position (g) described above and no interlayer member 600 are provided on the Z-direction side relative to the attachable face, a part of the unit U2 that is located on the Z-direction side relative to the attachable face of the or each fixable portion 102 (i.e., the cover 500) serves as a fifth accommodatable part. Where the fourth height position of the attachable face of the or each fixable portion 102 is the height position (g) described above and the interlayer member or members 600 are provided on the Z-direction side relative to the attachable face, the fifth accommodatable part includes the interlayer member or members 600, in addition to the cover 500.

Where the attachable face of the or each fixable portion 102 is in direct contact with the periphery of the first hole 11 of the housing 10 of the attachment target T, the first, second, third, fourth, or fifth accommodatable part has a dimension in the Z-Z' direction that is substantially identical to that of the hole H of the attachment target T. Where the attachable face of the or each fixable portion 102 is in indirect contact with the periphery of the first hole 11 of the housing 10 of the attachment target T via another member, such as an elastic body, the sum of dimensions in the Z-Z' direction of the first, second, third, fourth, or fifth accommodatable part and the another member is substantially identical to the dimension in the Z-Z' direction of the hole H of the attachment target T. Further, the first, second, third, fourth, or fifth accommodatable part of the unit U2 further includes configuration (C) or (D) below.

(C) The first, second, third, fourth, or fifth accommodatable part as viewed from the Z-direction side has an outer shape that is substantially identical to that of the hole H, and also has dimensions (projected area) as viewed from the Z-direction side that are substantially identical to those of the hole H. In the second attached state, the first, second, third, fourth, or fifth accommodatable part fits in the hole H of the attachment target T (see Fig. 5A). In this fitted state, a face on the most Z-direction side of the first, second, third, fourth, or fifth accommodatable part (the first face of the single cushion 200, the first face of the uppermost cushion 200, or the first face of the cover 500) of the unit U2 abuts the face on the Z'-direction side of the bottom portion of the hole H.

(D) The first, second, third, fourth, or fifth accommodatable part as viewed from the Z-direction side has an outer shape that is substantially identical to, or different from, that of the hole H, and has dimensions (projected area) as viewed from the Z-direction side that are smaller than those of the hole H. In the second attached state, the first, second, third, fourth, or fifth accommodatable part is accommodated in the hole H of the attachment target T (see Fig. 1A). In this accommodated state, a face on the most Z-direction side of the first, second, third, fourth, or fifth accommodatable part (the first face of the single cushion 200, the first face of the uppermost cushion 200, or the first face of the cover 500) of the unit U2 abuts the face on the Z'-direction side of the bottom portion of the hole H.

Noted that the outer surface layer 30 constituting the bottom portion on the Z-direction side of the hole H, or alternatively the bottom portion 21a and the outer surface layer 30 constituting the bottom portion on the Z-direction side of the hole H, have flexibility. Therefore, when the touch region of the bottom portion of the hole H is touched by a detection target, the bottom portion flexes so as to elastically deform the at least one cushion 200 of the first, second, third, fourth, or fifth accommodatable part.

In a state where the third or fourth accommodatable part is fitted or accommodated in the hole H as described above, a part of the cushion 200 or cushion set (cushions 200) that is located on the Z'-direction side relative to the attachable face is located on the Z'-direction side relative to the hole H. In a state where the fifth accommodatable part is fitted or accommodated in the hole H as described above, the cushion 200 or cushion set (cushions 200) in its entirety is located on the Z'-direction side relative to the hole H.

Note that the at least one fixable portion 102 may be omitted. In this case, the unit U2 may further include an attachment member (not illustrated), for example. The attachment member of the unit U2 includes the same configuration as the attachment member of the unit U1, except that the first portion of the attachment member is fixed from the Z'-direction side to the sensor body 101 of the detection sensor 100', rather than to the body 300, directly or indirectly via an elastic body or the like. Alternatively, where the first, second, third, fourth, or fifth accommodatable part includes configuration (C) described above, the unit U2 may be attached to the attachment target T by bonding the first, second, third, fourth, or fifth accommodatable part to the bottom surface on the Z'-direction side of the bottom portion of the hole H of the attachment target T and/or to the wall surface of the side wall surrounding the hole H, and/or by fitting into the hole H of the attachment target T. Where the first, second, third, fourth, or fifth accommodatable part includes configuration (D) above, the unit U2 may be attached to the attachment target T by bonding the first, second, third, fourth, or fifth accommodatable part to the bottom surface on the Z'-direction side of the bottom portion of the hole H of the attachment target T.

Where the cover 500 is not provided, the accommodatable part of any of the above aspects of the unit U2 may be modified in any manner as long as the at least one cushion 200 of the accommodatable part is accommodated at least partly in the hole H of the attachment target T. Where the cover 500 is provided, the accommodatable part of any of the above aspects of the unit U2 may be modified in any manner as long as at least one of the cover 500 or the at least one cushion 200 of the accommodatable part is accommodated at least partly in the hole H of the attachment target T.

The attachment structure and the unit U2 described above provide the first to third, fifth, and sixth technical features and effects of the unit U1.

Further, where the cover 500 is not provided, it is possible to set the height position in the Z-Z' direction of the sensor body 101 of the detection sensor 100' as desired by changing the dimension in the Z-Z' direction of the cushion or cushions 200 of the unit U2. Where the cover 500 is provided, it is possible to set the height position of the sensor body 101 of the detection sensor 100' in the Z-Z' direction as desired by changing the sum of the dimensions in the Z-Z' direction of the cushion or cushions 200 and the cover 500 of the unit U2.

Further, where the external connection part 400 is provided, in the second attached state, the external connection part 400 is led out in the Z' direction from the detection sensor 100' and through between the detection sensor 100' and the wall of the hole H of the attachment target T. This facilitates external connection of the detection sensor 100'.

### Third embodiment

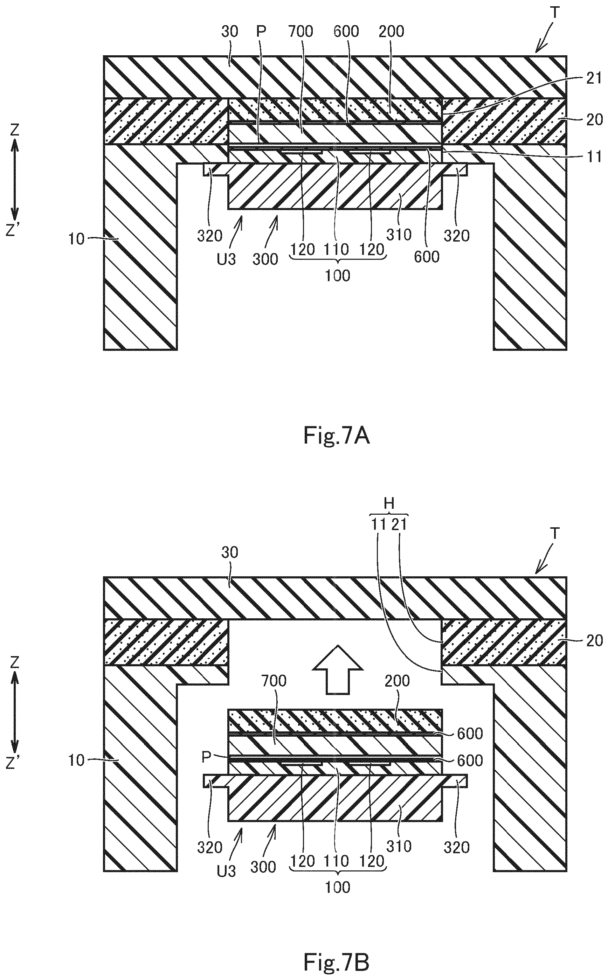

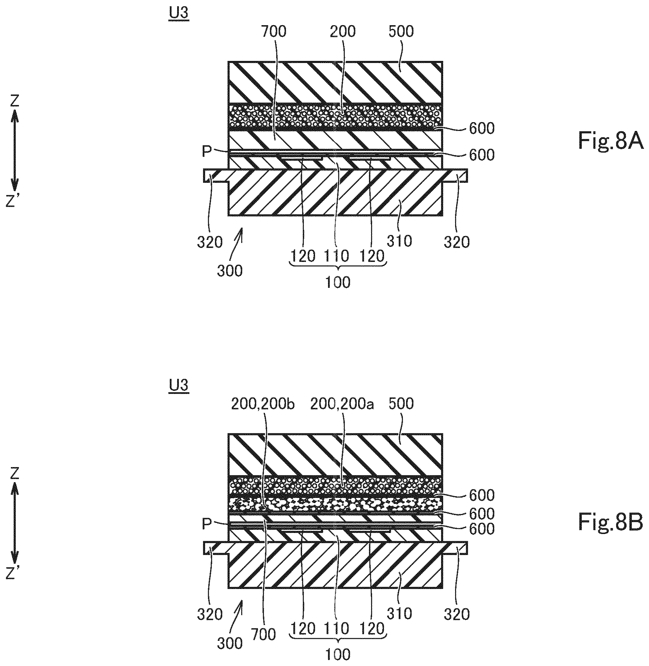

An attachment structure of a sensor unit U3 (which may be referred to simply as "unit U3") and an attachment target T according to a third embodiment and its modification examples of the invention will be hereinafter described with reference to Figs. 7A to 8B. Figs. 7A and 7B illustrate an attachment structure of the third embodiment. Fig. 8A illustrates a first variant of the unit U3 of the attachment structure of the third embodiment, and Fig. 8B illustrates a second variant of the unit U3 of the attachment structure of the third embodiment. Figs. 7A, 7B, 8A, and 8B also show the Z-Z' direction, similarly to the attachment structure of the first embodiment and its modification examples.

The attachment target T is as described for the first embodiment and its modification examples (see Figs. 7A, 7B, and 3A to 3B).

The unit U3 is attached to the attachment target T so as to be partly accommodated, from the Z'-direction side, in the hole H of the attachment target T described above. The state in which the unit U3 is thus attached to the attachment target T may also be referred to simply as a "third attached state".

The unit U3 includes the same configuration as the unit U1, except that the unit U3 is different from the unit U1 in further including at least one intermediate part 700. The unit U3 will now be described focusing on the differences from the unit U1 and omitting overlapping descriptions.

The at least one intermediate part 700 may be a single intermediate part 700 or a plurality of intermediate parts 700. For convenience of description, the at least one intermediate part 700 may be hereinafter referred to also as "the or each intermediate part 700" in a similar manner to the at least one sensor layer 110. The or each intermediate part 700 may be, but is not required to be, a support layer, a hard coat layer, an optical adjustment layer (polarizing plate, retardation plate, light condensing material, light diffusing material, or the like), or the like. Note that the support layer may be, but is not required to be, constituted by a flat glass plate, a flat plastic film or a flat plastic sheet, or a molded and shaped plastic article. The hard coat layer or the support layer may or may not be decorated.

The at least one intermediate part 700 is arranged between the detection sensor 100 and the at least one cushion 200. Where the at least one intermediate part 700 is the single intermediate parts 700 (see Figs. 7A to 8B), the intermediate part 700 includes a first face on the Z-direction side and a second face on the Z'-direction side. The first face of the intermediate part 700 may be in surface contact with the second face of the single cushion 200 or the second face of the lowermost cushion 200 of the plurality of cushions 200. Alternatively, the first face of the single intermediate part 700 may be in contact with the second face of the single cushion 200 or the second face of the lowermost cushion 200 of the plurality of cushions 200 via an interlayer member 600. Where the interlayer member 600 is an adhesive layer or a double-sided tape, the first face of the single intermediate part 700, the first face of the single intermediate part 700, and the second face of the single cushion 200 or the second face of the lowermost cushion 200 of the plurality of cushions 200 are bonded together with the interlayer member 600. The second face of the single intermediate part 700 may be in surface contact with the first face of the detection sensor 100. Alternatively, the second face of the single intermediate part 700 may be in contact with the first face of the detection sensor 100 each other via an interlayer member 600. Where the interlayer member 600 is an adhesive layer or a double-sided tape, the second face of the single intermediate part 700 and the first face of the detection sensor 100 are bonded together with the interlayer member 600.

Where the at least one intermediate part 700 is the plurality of intermediate parts 700 (not illustrated), the intermediate parts 700 are stacked in the Z-Z' direction. The plurality of intermediate parts 700 include an uppermost intermediate part 700 on the most Z-direction side and a lowermost intermediate part 700 on the most Z'-direction side. The uppermost intermediate part 700 includes a first face on the Z-direction side. The lowermost intermediate part 700 includes a second face on the Z'-direction side. The first face of the uppermost intermediate part 700 is in surface contact with the second face of the single cushion 200 or the second face of the lowermost cushion 200 of the plurality of cushions 200, or alternatively in contact with or bonded to the second face of the single cushion 200 or the second face of the lowermost cushion 200 of the plurality of cushions 200 via an interlayer member 600, in a similar manner to the single intermediate part 700. The second face of the lowermost intermediate part 700 is in surface contact with the first face of the detection sensor 100, or alternatively in contact with or bonded to the first face of the detection sensor 100 via the interlayer member 600, in a similar manner to the single intermediate part 700.

The plurality of intermediate parts 700 include at least one set of two intermediate parts 700 adjacent to each other in the Z-Z' direction. Of the two intermediate parts 700 adjacent to each other, the intermediate part 700 located on the Z-direction side may be hereinafter referred to also as a first intermediate part 700, and the intermediate part 700 located on the Z'-direction side as a second intermediate part 700. The first intermediate part 700 and the second intermediate part 700 may be in surface contact with each other or may be in contact with each other via an interlayer member 600. Where the interlayer member 600 is an adhesive layer or a double-sided tape, the first intermediate part 700 and the second intermediate part 700 are bonded together with the interlayer member 600. Where the plurality of intermediate parts 700 is two intermediate parts 700, the first intermediate part 700 is the uppermost intermediate part 700, and the second intermediate part 700 is the lowermost intermediate part 700. Where the plurality of intermediate parts 700 is three or more intermediate parts 700, the first intermediate part 700 is the uppermost intermediate part 700, the second intermediate part 700 is an intermediate part 700 that is located on the Z'-direction side relative to the uppermost intermediate part 700; alternatively, the second intermediate part 700 is the lowermost intermediate part 700, and the first intermediate part 700 is an intermediate part 700 that is located on the Z-direction side relative to the lower most intermediate part 700; or alternatively, the first and second intermediate parts 700 are intermediate parts 700 between the lowermost intermediate part 700 and the lowermost intermediate part 700.

The intermediate part or parts 700 may have an outer shape as viewed from the Z-direction side that is substantially identical to that of the detection sensor 100, and have outer dimensions (projected area) as viewed from the Z-direction side that are substantially identical to those of the detection sensor 100; and/or the intermediate part or parts 700 may have an outer shape as viewed from the Z-direction side that is substantially identical to that of the at least one cushion 200, and have outer dimensions (projected area) as viewed from the Z-direction side that are substantially identical to those of the at least one cushion 200.

Where the unit U3 includes the at least one exhaust path P, the at least one exhaust path P may be provided in at least one face of the second face of the single intermediate part 700 or the first face of the detection sensor 100, or alternatively in at least one face of the second face of the lowermost intermediate part 700 or the first face of the detection sensor 100. The at least one exhaust path P may open out to the at least one face and open out to a side face or faces that meet the at least one face. For example, the at least one exhaust path P may be a through hole or holes (not illustrated) or groove or grooves (see Fig. 4B), which extend along the at least one face, open out to the at least one face (at least one of the Z and Z' directions), and open out to a side face or faces that meet the at least one face. Where the detection sensor 100 includes the surface-treated portion, the at least one exhaust path P may be a through hole or holes or a groove or grooves provided in the first face of the surface-treated portion of the detection sensor 100.

Where the interlayer member 600 is interposed between the second face of the single intermediate part 700 or lowermost intermediate part 700 and the first face of the detection sensor 100, the at least one exhaust path P may be a through hole or holes or a groove or grooves provided in the interlayer member 600, which open out toward the at least one face of the second face of the intermediate part 700 or the first face of the detection sensor 100, or alternatively toward the at least one face of the second face of the lowermost intermediate part 700 or the first face of the detection sensor 100, and open out to a side face of the interlayer member 600. Even if the interlayer member 600 is provided, the at least one exhaust path P may be provided in other than the interlayer member 600 described above.

The at least one exhaust path P described above may be provided as a plurality of exhaust paths P. The at least one exhaust path P may be omitted.

Where the unit U3 is provided with the at least one fixable portion 320 of the body 300 and not with the cover 500, a "fifth height position" will hereinafter refer to a height position in the Z-Z' direction of the attachable face of the at least one fixable portion 320 of the body 300 of the unit U3 relative to the at least one intermediate part 700 and the at least one cushion 200. Where the unit U3 is provided with the at least one fixable portion 320 of the body 300 and the cover 500, a "sixth height position" will hereinafter refer to a height position in the Z-Z' direction of the attachable face of the at least one fixable portion 320 of the body 300 of the unit U3 relative to the at least one intermediate part 700, the at least one cushion 200, and the cover 500. The fifth or sixth height position of the attachable face of the or each fixable portion 320 may be set as desired by increasing a thickness dimension of the or each fixable portion 320 in the Z-Z' direction or by configuring the or each fixable portion 320 to extend in the Z-Z' direction. For example, the fifth or sixth height position of the attachable face of the or each fixable portion 320 may be the height positions (a), (b), or (c) described above. Alternatively, the sixth height position of the attachable face of the or each fixable portion 320 may be the height position (d) described above.

Where the fifth height position of the attachable face of the or each fixable portion 320 is the height position (a) described above and no interlayer member 600 are provided on the Z-direction side relative to the attachable face, a part of the unit U3 that is located on the Z-direction side relative to the attachable face of the or each fixable portion 320 (i.e., the detection sensor 100, the intermediate part or parts 700, and the cushion or cushions 200) serves as a first accommodatable part (see Figs. 7A and 7B). Where the fifth height position of the attachable face of the or each fixable portion 320 is the height position (a) described above and the interlayer member or members 600 are provided on the Z-direction side relative to the attachable face, the first accommodatable part includes the interlayer member or members 600, in addition to the detection sensor 100, the intermediate part or parts 700, and the cushion or cushions 200. Where the sixth height position of the attachable face of the or each fixable portion 320 is the height position (a) described above and no interlayer member 600 are provided on the Z-direction side relative to the attachable face, a part of the unit U3 that is located on the Z-direction side relative to the attachable face of the or each fixable portion 320 (i.e., the detection sensor 100, the intermediate part or parts 700, the cushion or cushions 200, and the cover 500) serves as a second accommodatable part (see Figs. 8A and 8B). Where the sixth height position of the attachable face of the or each fixable portion 320 is the height position (a) described above and the interlayer member or members 600 are provided on the Z-direction side relative to the attachable face, the second accommodatable part includes the interlayer member or members 600, in addition to the detection sensor 100, the intermediate part or parts 700, the cushion or cushions 200, and the cover 500.

Where the fifth height position of the attachable face of the or each fixable portion 320 is the height position (b) described above and no interlayer member 600 are provided on the Z-direction side relative to the attachable face, a part of the unit U3 that is located on the Z-direction side relative to the attachable face of the or each fixable portion 320 (i.e., the intermediate part or parts 700 and the cushion or cushions 200) serves as a third accommodatable part. Where the fifth height position of the attachable face of the or each fixable portion 320 is the height position (b) described above and the interlayer member or members 600 are provided on the Z-direction side relative to the attachable face, the third accommodatable part includes the interlayer member or members 600, in addition to the intermediate part or parts 700 and the cushion or cushions 200. Where the sixth height position of the attachable face of the or each fixable portion 320 is the height position (b) described above and no interlayer member 600 are provided on the Z-direction side relative to the attachable face, a part of the unit U3 that is located on the Z-direction side relative to the attachable face of the or each fixable portion 320 (i.e., the intermediate part or parts 700, the cushion or cushions 200, and the cover 500) serves as a fourth accommodatable part. Where the sixth height position of the attachable face of the or each fixable portion 320 is the height position (b) described above and the interlayer member or members 600 are provided on the Z-direction side relative to the attachable face, the fourth accommodatable part includes the interlayer member or members 600, in addition to the intermediate part or parts 700, the cushion or cushions 200, and the cover 500.

Where the fifth height position of the attachable face of the or each fixable portion 320 is the height position (c) described above and no interlayer member 600 are provided on the Z-direction side relative to the attachable face, a part of the unit U3 that is located on the Z-direction side relative to the attachable face of the or each fixable portion 320 (i.e., a part of the cushion 200 or cushion set (cushions 200) that is located on the Z-direction side relative to the or each fixable portion 320) serves as a fifth accommodatable part. Where the fifth height position of the attachable face of the or each fixable portion 320 is the height position (c) described above and the interlayer member or members 600 are provided on the Z-direction side relative to the attachable face, the fifth accommodatable part includes the interlayer member or members 600, in addition to the part of the cushion 200 or cushion set (cushions 200) that is located on the Z-direction side relative to the or each fixable portion 320. Where the sixth height position of the attachable face of the or each fixable portion 320 is the height position (c) described above and no interlayer member 600 are provided on the Z-direction side relative to the attachable face, a part of the unit U3 that is located on the Z-direction side relative to the attachable face of the or each fixable portion 320 (i.e., a part of the cushion 200 or cushion set (cushions 200) that is located on the Z-direction side relative to the or each fixable portion 320, and the cover 500) serves as a sixth accommodatable part. Where the sixth height position of the attachable face of the or each fixable portion 320 is the height position (c) described above and the interlayer member or members 600 are provided on the Z-direction side relative to the attachable face, the sixth accommodatable part includes the interlayer member or members 600, in addition to the part of the cushion 200 or cushion set (cushions 200) that is located on the Z-direction side relative to the or each fixable portion 320 and the cover 500.

Where the sixth height position of the attachable face of the or each fixable portion 320 is the height position (d) described above and no interlayer member 600 are provided on the Z-direction side relative to the attachable face, a part of the unit U3 that is located on the Z-direction side relative to the attachable face of the or each fixable portion 320 (i.e., the cover 500) serves as a seventh accommodatable part. Where the sixth height position of the attachable face of the or each fixable portion 320 is the height position (d) described above and the interlayer member or members 600 are provided on the Z-direction side relative to the attachable face, the seventh accommodatable part includes the interlayer member or members 600, in addition to the cover 500.

Where the attachable face of the or each fixable portion 320 is in direct contact with the periphery of the first hole 11 of the housing 10 of the attachment target T, the first, second, third, fourth, fifth, sixth, or seventh accommodatable part of the unit U3 has a dimension in the Z-Z' direction that is substantially identical to that of the hole H of the attachment target T. Where the attachable face of the or each fixable portion 320 is in indirect contact with the periphery of the first hole 11 of the housing 10 of the attachment target T via another member, such as an elastic body, the sum of dimensions in the Z-Z' direction of the first, second, third, fourth, fifth, sixth, or seventh accommodatable part and the another member is substantially identical to the dimension in the Z-Z' direction of the hole H of the attachment target T. The first, second, third, fourth, fifth, sixth, or seventh accommodatable part of the unit U3 further includes a configuration (E) or (F) below.

(E) The first, second, third, fourth, fifth, sixth, or seventh accommodatable part as viewed from the Z-direction side has an outer shape that is substantially identical to that of the hole H, and also has outer dimensions (projected area) as viewed from the Z-direction side that are substantially identical to those of the hole H. In the third attached state, the first, second, third, fourth, fifth, sixth, or seventh accommodatable part fits in the hole H of the attachment target T (see Fig. 7A). In this fitted state, a face on the most Z-direction side of the first, second, third, fourth, fifth, sixth, or seventh accommodatable part (the first face of the single cushion 200, the first face of the uppermost cushion 200, or the first face of the cover 500) of the unit U3 abuts the face on the Z'-direction side of the bottom portion of the hole H.

(F) The first, second, third, fourth, fifth, sixth, or seventh accommodatable part as viewed from the Z-direction side has an outer shape that is substantially identical to, or different from, that of the hole H, and has outer dimensions (projected area) as viewed from the Z-direction side that are smaller than those of the hole H. In the third attached state, the first, second, third, fourth, fifth, sixth, or seventh accommodatable part is accommodated in the hole H of the attachment target T (see Fig. 1A). In this accommodated state, a face on the most Z-direction side of the first, second, third, fourth, fifth, sixth, or seventh accommodatable part (the first face of the single cushion 200, the first face of the uppermost cushion 200, or the first face of the cover 500) of the unit U3 abuts the face on the Z'-direction side of the bottom portion of the hole H.

Noted that the outer surface layer 30 constituting the bottom portion on the Z-direction side of the hole H, or alternatively the bottom portion 21a and the outer surface layer 30 constituting the bottom portion on the Z-direction side of the hole H, have flexibility. Therefore, when the touch region of the bottom portion of the hole H is touched by a detection target, the bottom portion flexes so as to elastically deform the at least one cushion 200 of the first, second, third, fourth, fifth, sixth, or seventh accommodatable part.

In a state where the third or fourth accommodatable part is fitted or accommodated in the hole H as described above, the detection sensor 100 in its entirety is located on the Z'-direction side relative to the hole H. In a state where the fifth or sixth accommodatable part is fitted or accommodated in the hole H as described above, the detection sensor 100 in its entirety, the intermediate part 700 or intermediate part set (intermediate parts 700) in its entirety, and a part of the cushion 200 or cushion set (cushions 200) that is located on the Z'-direction side relative to the attachable face are located on the Z'-direction side relative to the hole H. In a state where the seventh accommodatable part is fitted or accommodated in the hole H as described above, the detection sensor 100 in its entirety, the intermediate part 700 or intermediate part set (intermediate parts 700) in its entirety, and the cushion 200 or cushion set (cushions 200) in its entirety are located on the Z'-direction side relative to the hole H.

Where the holder 310 is constituted by the box, the accommodation hole of the box of the holder 310 may accommodate one of the following: the detection sensor 100 located on the Z'-direction side relative to the third or fourth accommodatable part; the detection sensor 100, the intermediate part or parts 700, and the part of the cushion 200 or cushion set (cushions 200) located on the Z'-direction side relative to the fifth or sixth accommodatable part; or the detection sensor 100, the intermediate part or parts 700, and the cushion or cushions 200 located on the Z'-direction side relative to the seventh accommodatable part. The part of the cushion 200 or cushion set (cushions 200) is located on the Z'-direction side relative to the attachable face.

Alternatively, where the holder 310 is constituted by the box, and the first, second, third, fourth, fifth, sixth, or seventh accommodatable part includes configuration (F) above, at least a portion on the Z'-direction side of the first or second accommodatable part(the portion on the Z'-direction side of the first or second accommodatable part, or alternatively the first or second accommodatable part in its entirety) may be accommodated in the accommodation hole of the box of the holder 310; at least a portion on the Z'-direction side of the third or fourth accommodatable part (the portion on the Z'-direction side of the third or fourth accommodatable part, or alternatively the third or fourth accommodatable part in its entirety) may be accommodated in the accommodation hole of the box of the holder 310, and the detection sensor 100 located on the Z'-direction side relative to the third or fourth accommodatable part may be accommodated in the accommodation hole of the box of the holder 310; at least a portion on the Z'-direction side of the fifth or sixth accommodatable part (the portion on the Z'-direction side of the fifth or sixth accommodatable part, or alternatively the fifth or sixth accommodatable part in its entirety) may be accommodated in the accommodation hole of the box of the holder 310, and the detection sensor 100, the intermediate part or parts 700, and the part of the cushion 200 or cushion set (cushions 200) located on the Z'-direction side relative to the fifth or sixth accommodatable part may be accommodated in the accommodation hole of the box of the holder 310; at least a portion on the Z'-direction side of the seventh accommodatable part (the portion on the Z'-direction side of the seventh accommodatable part, or alternatively the seventh accommodatable part in its entirety) may be accommodated in the accommodation hole of the box of the holder 310, and the detection sensor 100, the intermediate part or parts 700, and the cushion or cushions 200 located on the Z'-direction side relative to the seventh accommodatable part may be accommodated in the accommodation hole of the box of the holder 310. The part of the cushion 200 or cushion set (cushions 200) is located on the Z'-direction side relative to the attachable face. In this case, the side wall of the holder 310 may have a dimension in the Z-Z' direction that is substantially identical to, or smaller than, that of the hole H of the attachment target T, and the holder 310 may have an outer shape as viewed from the Z-direction side may be identical to the shape of the hole H viewed from the Z-direction side, and the holder 310 may have outer dimensions (projected area) as viewed from the Z-direction side may be substantially identical to dimensions (projected area) of the hole H as viewed from the Z-direction side. In this case, the holder 310 may preferably, but is not required to, fit in the hole H of the attachment target T in the third attached state.

The at least one fixable portion 230 may be provided in the at least one intermediate part 700 rather than in the body 300. In this case, the at least one fixable portion 230 may include any configurations described above except that the at least one fixable portion 230 is provided in the at least one intermediate part 700.

Where the at least one fixable portion 230 is omitted, for example, the unit U3 may further include an attachment member (not illustrated). The attachment member of the unit U3 may preferably include the same configuration as the attachment member of the unit U1. Where the first, second, third, fourth, fifth, sixth, or seventh accommodatable part includes configuration (E) described above, the unit U3 may be attached to the attachment target T by bonding the first, second, third, fourth, fifth, sixth, or seventh accommodatable part to the bottom surface on the Z'-direction side of the bottom portion of the hole H of the attachment target T and/or to the wall surface of the side wall surrounding the hole H, and/or by fitting into the hole H of the attachment target T. Where the first, second, third, fourth, fifth, sixth, or seventh accommodatable part includes configuration (F) described above, the unit U3 may be attached to the attachment target T by bonding the first, second, third, fourth, fifth, sixth, or seventh accommodatable part to the bottom surface on the Z'-direction side of the bottom portion of the hole H of the attachment target T. Where the first, second, third, fourth, fifth, sixth, or seventh accommodatable part includes configuration (F) described above and the holder 310 fits in the hole H of the attachment target T, the unit U3 may be attached to the attachment target T by fitting the holder 310 into the hole H of the attachment target T and/or by bonding the holder 310 to the wall surface of the side wall surrounding the hole H of the attachment target T.

Where the cover 500 is not provided, the accommodatable part of any of the above aspects of the unit U3 may be modified in any manner as long as the at least one cushion 200 of the accommodatable part is accommodated at least partly in the hole H of the attachment target T. Where the cover 500 is provided, the accommodatable part of any of the above aspects of the unit U3 may be modified in any manner as long as at least one of the cover 500 or the at least one cushion 200 of the accommodatable part is accommodated at least partly in the hole H of the attachment target T.

The attachment structure and the unit U3 described above provide the first to third and fifth to seventh technical features and effects of the unit U1.

Further, where the cover 500 is not provided, it is possible to set the height position in the Z-Z' direction of the detection sensor 100 as desired by changing the sum of the dimensions in the Z-Z' direction of the intermediate part or parts 700 and the cushion or cushions 200 of the unit U3. Where the cover 500 is provided, it is possible to set the height position of the detection sensor 100 in the Z-Z' direction as desired by changing the sum of the dimensions in the Z-Z' direction of the intermediate part or parts 700, the cushion or cushions 200, and the cover 500 of the unit U3.

### Fourth embodiment

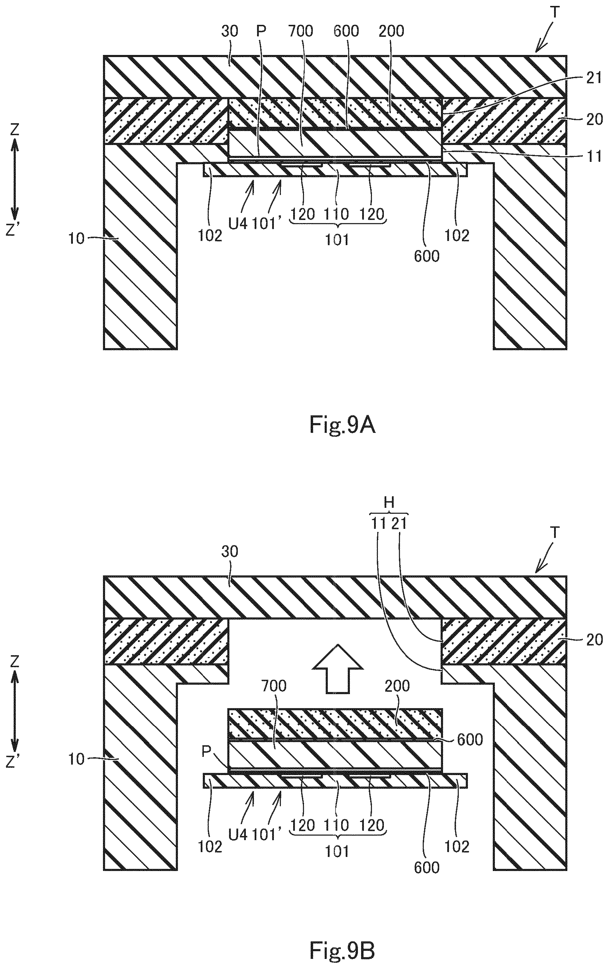

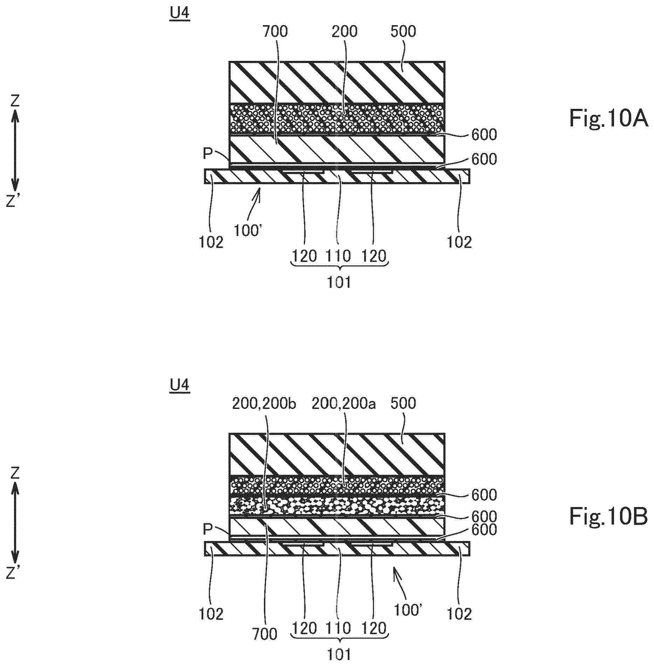

An attachment structure of a sensor unit U4 (which may be referred to simply as "unit U4") and an attachment target T according to a fourth embodiment and its modification examples of the invention will be hereinafter described with reference to Figs. 9A to 10B. Figs. 9A and 9B illustrate an attachment structure of the fourth embodiment. Fig. 10A illustrates a first variant of the unit U4 of the attachment structure of the fourth embodiment, and Fig. 10B illustrates a second variant of the unit U4 of the attachment structure of the fourth embodiment. Figs. 9A, 9B, 10A, and 10B also show the Z-Z' direction, similarly to the attachment structure of the second embodiment and its modification examples.

The attachment target T is as described for the first embodiment and its modification examples (see Figs. 9A, 9B, and 3A to 3B).

The unit U4 is attached to the attachment target T so as to be partly accommodated, from the Z'-direction side, in the hole H of the attachment target T described above. The state in which the unit U4 is thus attached to the attachment target T may also be referred to simply as a " fourth attached state".

The unit U4 includes the same configuration as the unit U2, except that the unit U4 is different from the unit U2 in further including at least one intermediate part 700. The unit U4 will now be described focusing on the differences from the unit U2 and omitting overlapping descriptions.

The at least one intermediate part 700 of the unit U4 may include the same configuration as the at least one intermediate part 700 of the unit U3. Where the unit U4 includes the at least one exhaust path P, the at least one exhaust path P of the unit U4 may include the same configuration as the at least one exhaust path P of the unit U3. The at least one exhaust path P of the unit U4 may also be omitted.

Where the unit U4 is provided with the at least one fixable portion 102 of the detection sensor 100' and not with the cover 500, a "seventh height position" will hereinafter refer to a height position in the Z-Z' direction of the attachable face of the at least one fixable portion 102 of the detection sensor 100' of the unit U4 relative to the at least one intermediate part 700 and the at least one cushion 200. Where the unit U4 is provided with the at least one fixable portion 102 of the detection sensor 100' and the cover 500, an "eighth height position" will hereinafter refer to a height position in the Z-Z' direction of the attachable face of the at least one fixable portion 102 of the detection sensor 100' of the unit U4 relative to the at least one intermediate part 700, the at least one cushion 200, and the cover 500. The seventh or eighth height position of the attachable face of the or each fixable portion 102 may be set as desired by increasing a thickness dimension of the or each fixable portion 102 in the Z-Z' direction or by configuring the or each fixable portion 102 to extend in the Z-Z' direction. For example, the seventh or eighth height position of the attachable face of the or each fixable portion 102 may be the height positions (e) or (f) described above. Alternatively, the eighth height position of the attachable face of the or each fixable portion 102 may be the height position (g) described above.

Where the seventh height position of the attachable face of the or each fixable portion 102 is the height position (e) described above and no interlayer member 600 are provided on the Z-direction side relative to the attachable face, a part of the unit U4 that is located on the Z-direction side relative to the attachable face of the or each fixable portion 102 (i.e., the intermediate part or parts 700 and the cushion or cushions 200) serves as a first accommodatable part. Where the seventh height position of the attachable face of the or each fixable portion 102 is the height position (e) described above and the interlayer member or members 600 are provided on the Z-direction side relative to the attachable face, the first accommodatable part includes the interlayer member or members 600, in addition to the intermediate part or parts 700 and the cushion or cushions 200. Where the eighth height position of the attachable face of the or each fixable portion 102 is the height position (e) described above and no interlayer member 600 are provided on the Z-direction side relative to the attachable face, a part of the unit U4 that is located on the Z-direction side relative to the attachable face of the or each fixable portion 102 (i.e., the intermediate part or parts 700, the cushion or cushions 200, and the cover 500) serves as a second accommodatable part (see Figs. 8A and 8B). Where the eighth height position of the attachable face of the or each fixable portion 102 is the height position (e) described above and the interlayer member or members 600 are provided on the Z-direction side relative to the attachable face, the second accommodatable part includes the interlayer member or members 600, in addition to the intermediate part or parts 700, the cushion or cushions 200, and the cover 500.

Where the seventh height position of the attachable face of the or each fixable portion 102 is the height position (f) described above and no interlayer member 600 are provided on the Z-direction side relative to the attachable face, a part of the unit U4 that is located on the Z-direction side relative to the attachable face of the or each fixable portion 102 (i.e., a part of the cushion 200 or cushion set (cushions 200) that is located on the Z-direction side relative to the or each fixable portion 320) serves as a third accommodatable part. Where the seventh height position of the attachable face of the or each fixable portion 102 is the height position (f) described above and the interlayer member or members 600 are provided on the Z-direction side relative to the attachable face, the third accommodatable part includes the interlayer member or members 600, in addition to the part of the cushion 200 or cushion set (cushions 200) that is located on the Z-direction side relative to the or each fixable portion 320. Where the eighth height position of the attachable face of the or each fixable portion 102 is the height position (f) described above and no interlayer member 600 are provided on the Z-direction side relative to the attachable face, a part of the unit U4 that is located on the Z-direction side relative to the attachable face of the or each fixable portion 102 (i.e., a part of the cushion 200 or cushion set (cushions 200) that is located on the Z-direction side relative to the or each fixable portion 320, and the cover 500) serves as a fourth accommodatable part. Where the eighth height position of the attachable face of the or each fixable portion 102 is the height position (f) described above and the interlayer member or members 600 are provided on the Z-direction side relative to the attachable face, the fourth accommodatable part includes the interlayer member or members 600, in addition to the part of the cushion 200 or cushion set (cushions 200) that is located on the Z-direction side relative to the or each fixable portion 320 and the cover 500.

Where the eighth height position of the attachable face of the or each fixable portion 102 is the height position (g) described above and no interlayer member 600 are provided on the Z-direction side relative to the attachable face, a part of the unit U4 that is located on the Z-direction side relative to the attachable face of the or each fixable portion 102 (i.e., the cover 500) serves as a fifth accommodatable part. Where the eighth height position of the attachable face of the or each fixable portion 102 is the height position (g) described above and the interlayer member or members 600 are provided on the Z-direction side relative to the attachable face, the fifth accommodatable part includes the interlayer member or members 600, in addition to the cover 500.

Where the attachable face of the or each fixable portion 102 is in direct contact with the periphery of the first hole 11 of the housing 10 of the attachment target T, the first, second, third, fourth, or fifth accommodatable part has a dimension in the Z-Z' direction that is substantially identical to that of the hole H of the attachment target T. Where the attachable face of the or each fixable portion 102 is in indirect contact with the periphery of the first hole 11 of the housing 10 of the attachment target T via another member, such as an elastic body, the sum of dimensions in the Z-Z' direction of the first, second, third, fourth, or fifth accommodatable part and the another member is substantially identical to the dimension in the Z-Z' direction of the hole H of the attachment target T. Also, the first, second, third, fourth, or fifth accommodatable part of the unit U4 further includes a configuration (G) or (H) below.

(G) The first, second, third, fourth, or fifth accommodatable part as viewed from the Z-direction side has an outer shape that is substantially identical to that of the hole H, and also has outer dimensions (projected area) as viewed from the Z-direction side that are substantially identical to those of the hole H. In the fourth attached state, the first, second, third, fourth, or fifth accommodatable part fits in the hole H of the attachment target T (see Fig. 9A). In this fitted state, a face on the most Z-direction side of the first, second, third, fourth, or fifth accommodatable part (the first face of the single cushion 200, the first face of the uppermost cushion 200, or the first face of the cover 500) of the unit U4 abuts the face on the Z'-direction side of the bottom portion of the hole H.

(H) The first, second, third, fourth, or fifth accommodatable part as viewed from the Z-direction side has an outer shape that is substantially identical to, or different from, that of the hole H, and has outer dimensions (projected area) as viewed from the Z-direction side that are smaller than those of the hole H. In the fourth attached state, the first, second, third, fourth, or fifth accommodatable part is accommodated in the hole H of the attachment target T (see Fig. 1A). In this accommodated state, a face on the most Z-direction side of the first, second, third, fourth, or fifth accommodatable part (the first face of the single cushion 200, the first face of the uppermost cushion 200, or the first face of the cover 500) of the unit U4 abuts the face on the Z'-direction side of the bottom portion of the hole H.

Noted that the outer surface layer 30constituting the bottom portion on the Z-direction side of the hole H, or alternatively the bottom portion 21a and the outer surface layer 30 constituting the bottom portion on the Z-direction side of the hole H, have flexibility. Therefore, when the touch region of the bottom portion of the hole H is touched by a detection target, the bottom portion flexes so as to elastically deform the at least one cushion 200 of the first, second, third, fourth, or fifth accommodatable part.

In a state where the third or fourth accommodatable part is fitted or accommodated in the hole H as described above, the intermediate part 700 or intermediate part set (intermediate parts 700) in its entirety, and a part of the cushion 200 or cushion set (cushions 200) that is located on the Z'-direction side relative to the attachable face are located on the Z'-direction side relative to the hole H. In a state where the fifth accommodatable part is fitted or accommodated in the hole H as described above, the intermediate part 700 or intermediate part set (intermediate parts 700) in its entirety, and the cushion 200 or cushion set (cushions 200) in its entirety are located on the Z'-direction side relative to the hole H.

The at least one fixable portion 102 may be provided in the at least one intermediate part 700 rather than in the detection sensor 100'. In this case, the at least one fixable portion 102 may include any configurations described above except that the at least one fixable portion 102 is provided in the at least one intermediate part 700.

Note that the at least one fixable portion 102 may be omitted. In this case, for example, the unit U4 may further include an attachment member (not illustrated). The attachment member of the unit U4 may preferably include the same configuration as the attachment member of the unit U2. Alternatively, where the first, second, third, fourth, or fifth accommodatable part includes configuration (G) described above, the unit U4 may be attached to the attachment target T by bonding the first, second, third, fourth, or fifth accommodatable part to the bottom surface on the Z'-direction side of the bottom portion of the hole H of the attachment target T and/or to the wall surface of the side wall surrounding the hole H, and/or by fitting into the hole H of the attachment target T. Where the first, second, third, fourth, or fifth accommodatable part includes configuration (H) described above, the unit U4 may be attached to the attachment target T by bonding the first, second, third, fourth, or fifth accommodatable part to the bottom surface on the Z'-direction side of the bottom portion of the hole H of the attachment target T.

Where the cover 500 is not provided, the accommodatable part of any of the above aspects of the unit U3 may be modified in any manner as long as the at least one cushion 200 of the accommodatable part is accommodated at least partly in the hole H of the attachment target T. Where the cover 500 is provided, the accommodatable part of any of the above aspects of the unit U3 may be modified in any manner as long as at least one of the cover 500 or the at least one cushion 200 of the accommodatable part is accommodated at least partly in the hole H of the attachment target T.

The attachment structure and the unit U4 described above provide the first to third, fifth, and sixth technical features and effects of the unit U1.

Further, where the cover 500 is not provided, it is possible to set the height position in the Z-Z' direction of the detection sensor 100' as desired by changing the sum of the dimensions in the Z-Z' direction of the intermediate part or parts 700 and the cushion or cushions 200 of the unit U4. Where the cover 500 is provided, it is possible to set the height position of the detection sensor 100' in the Z-Z' direction as desired by changing the sum of the dimensions in the Z-Z' direction of the intermediate part or parts 700, the cushion or cushions 200, and the cover 500 of the unit U4.

Further, where the external connection part 400 is provided, in the fourth attached state, the external connection part 400 is led out in the Z' direction from the detection sensor 100' and through between the detection sensor 100' and the wall of the hole H of the attachment target T. This facilitates external connection of the detection sensor 100'.

It should be noted that the attachment structures and the sensor units described above are not limited to those in the above embodiment, and modified as appropriate within the scope of the claims. Some examples of modification are described below.

Where the unit U1 or U3 includes the controller, the body 300 of the unit U1 or U3 may be configured to hold a control board mounted with the controller or configured to be mounted with the controller. Where the unit U2 or U4 includes the controller, the at least one sensor layer of the detection sensor of the unit U2 or U4 may be configured to be mounted with the controller or configured to hold a control board mounted with the controller.

The body 300 or the attachment member may be configured to hold an illumination part, such as an LED, to emit light in the Z direction. In the first or third attached state, light from the illumination part will be emitted onto the touch region. Also, the body 300 or the attachment member may hold a polarizing plate, retardation plate, a light condensing member, a light diffusing member, or like member, which is located on the Z-direction side relative to the illumination part. Also, the body 300 or the attachment member may hold a vibrator. In this case, the controller may be configured to drive the vibrator, when determining that the touch region is touched by a detection target as in a manner described above, so as to vibrate the unit of any of the above aspects. Further, the body 300 or the attachment member may hold a pressing mechanism.

At least one of the at least one cushion 200, the cover 500, and the at least one intermediate part 700 may be provided with a printed layer provided with one or a plurality of translucent portions serving as an icon or the like. The one or plurality of translucent portions are located on the Z-direction side relative to the illumination part provided in the body 300 or the attachment member or provided in the housing, and have enough translucency to transmit light emitted from the illumination part. The detection sensor 100 is located in the Z-Z' direction between the one or plurality of translucent portions and the illumination part, and have enough translucency to transmit light emitted from the illumination part.

The attachment target of any of the aspects described above may be modified in any manner design as long as the attachment target has a hole opening out at least in the Z' direction. For example, the hole H may be a through hole extending through the attachment target T in the Z-Z' direction and opening out in both Z' and Z directions. In this case, the bottom portion of the hole H is omitted. In this case, the first, second, third, fourth, fifth, sixth, or seventh accommodatable part of the unit of any of the above aspects is accommodated in the hole H in a manner as described above. The dimension in the Z-Z' direction of the first, second, third, fourth, fifth, sixth, or seventh accommodatable part of the unit of any of the above aspects may be substantially the same as, smaller than, or larger than, the dimension in the Z-Z' direction of the hole H of the attachment target T. In other words, the face on the most Z-direction side of the first, second, third, fourth, fifth, sixth, or seventh accommodatable part of the unit of any of the above aspects may be flush with, or located on the Z'- or Z- direction side relative to, the face on the Z-direction side of the periphery of the hole H. Where the face on the most Z-direction side of the first, second, third, fourth, fifth, sixth, or seventh accommodatable part of the unit of any of the above aspects is located on the Z-direction side relative to the face on the Z-direction side of the periphery of the hole H and the first, second, third, fourth, fifth, sixth, or seventh accommodatable part includes the cover 500, the cover 500 may be located on the Z-direction side relative to the hole H, and the hole H may accommodate at least a part of the at least one cushion 200 of the first, second, third, fourth, fifth, sixth, or seventh accommodatable part. The attachment target T may not include the touch region, but instead, the face on the most Z-direction side of the first, second, third, fourth, fifth, sixth, or seventh accommodatable part of the unit of any of the above aspects may include a touch region.

The accommodatable part of the unit of any of the above aspects may be modified in any manner design as long as the accommodatable part is located on the Z-direction side relative to the fixable face of any of the above aspects or relative to the face on the Z-direction side of the second portion of the attachment member, and is partly accommodated, from the Z'-direction side, in the hole of the attachment target of any of the above aspects. The dimension in the Z-Z' direction of the accommodatable part may be determined by appropriately adjusting the dimension in the Z-Z' direction of each element constituting the accommodatable part.

The first direction of the invention may be any direction along which the at least one cushion and the detection sensor of the invention are arranged. The orthogonal direction of the invention may be any direction that is substantially orthogonal to the first direction.

### Reference Signs List

T: attachment target
   10: housing; 20: cushion layer; 30: outer surface layer
H: hole of attachment target
   11: first hole; 21: second hole
U1 to U4: sensor unit
   100, 100': detection sensor
      110: sensor layer; 120: first electrode, second electrode; 101: sensor body; 102: fixable portion
   200 (200a, 200b): cushion
   300: body
      310: holder; 320: fixable portion
   400: external connection part
   500: cover
   600: interlayer member
   700: intermediate part
   P: exhaust path

## Claims

1. An attachment structure for a sensor unit (U1, U2, U3, U4) and an attachment target (T), the attachment structure comprising:
the attachment target (T) having a hole (H) opening out at least to one side (Z') in a first direction (Z-Z'), the attachment target (T) comprising:
a housing (10), the hole (H) including a first hole (11) extending through the housing (10) in the first direction (Z-Z'), and
an outer surface layer (30) being composed of a natural, artificial, or synthetic leather, a cloth of fibrous material, such as a woven fabric or knitted fabric, a synthetic resin film, covering the housing (10) entirely or partly from the other side (Z) in the first direction (Z-Z'), and closing the first hole (11) from the other side (Z) in the first direction (Z-Z'), wherein a portion of the outer surface layer (30) that is located on the other side (Z) in the first direction (Z-Z') relative to the first hole (11) forms a bottom portion of the hole (H); and
the sensor unit (U1, U2, U3, U4) attached to the attachment target (T) from the one side (Z') in the first direction (Z-Z') so as to be partly accommodated, from the one side (Z') in the first direction (Z-Z'), in the hole (H), the sensor unit (U1, U2, U3, U4) comprising:
a detection sensor (100, 100') being a touch sensor or a pressure sensor and configured to be able to detect approach of a detection target from the other side (Z) in the first direction (Z-Z'); and
at least one cushion (200) covering the detection sensor (100, 100') at least partly from the other side (Z) in the first direction (Z-Z'), wherein the at least one cushion (200) is at least partly accommodated in the hole (H) of the attachment target (T) in a state where the sensor unit (U1, U2, U3, U4) is attached to the attachment target (T) from the one side (Z') in the first direction (Z-Z'),
wherein the first direction (Z-Z') is a direction along which the at least one cushion (200) and the detection sensor (100, 100') are arranged.

2. The attachment structure according to claim 1, wherein
the sensor unit (U1, U2, U3, U4) further comprising a cover (500) covering the at least one cushion (200) and the detection sensor (100, 100') from the other side (Z) in the first direction (Z-Z'), and
the cover (500) or the at least one cushion (200), or alternatively both the cover (500) and the at least one cushion (200), are at least partly accommodated in the hole (H) of the attachment target (T) in a state where the sensor unit (U1, U2, U3, U4) is attached to the attachment target (T) from the one side (Z') in the first direction (Z-Z').

3. The attachment structure according to claim 1 or 2, wherein
the sensor unit (U1, U3) further comprises a body (300) including a holder (310),
the holder (310) is a box opening out to the other side (Z) in the first direction (Z-Z'), accommodates the detection sensor (100) and at least a part of the at least one cushion (200), and the holder (310) is at least partly accommodated in the hole (H) of the attachment target (T) in a state where the sensor unit (U1, U3) is attached to the attachment target (T) from the one side (Z') in the first direction (Z-Z').

4. The attachment structure according to claim 1 or 2, wherein
the sensor unit (U1, U3) further comprises a body (300), the body (300) including:
a holder (310) being located on the one side (Z') in the first direction (Z-Z') relative to the detection sensor (100) and holding the detection sensor (100) and
at least one fixable portion (320) being located outside the detection sensor (100) in a direction substantially orthogonal to the first direction (Z-Z') and fixable to the attachment target (T) from the one side (Z') in the first direction (Z-Z').

5. The attachment structure according to claim 1 or 2, wherein
the sensor unit (U1, U3) further comprises:
a body (300) including a holder (310), the holder (310) being located on the one side (Z') in the first direction (Z-Z') relative to the detection sensor (100) and holding the detection sensor (100); and
an attachment member being fixed to the body (300) and fixed to the attachment target (T) from the one side (Z') in the first direction (Z-Z').

6. The attachment structure according to claim 1 or 2, wherein
the detection sensor (100') includes:
a sensor body (101) being the touch sensor or the pressure sensor and configured to be able to detect approach of a detection target from the other side (Z) in the first direction (Z-Z'); and
at least one fixable portion (102) being located outside the sensor body (101) in a direction substantially orthogonal to the first direction (Z-Z') and fixed to the attachment target (T) from the one side (Z') in the first direction (Z-Z').

7. The attachment structure according to claim 1 or 2, wherein
the sensor unit (U2, U4) further comprising an attachment member, and
the attachment member is fixed to the detection sensor (100') and fixed to the attachment target (T) from the one side (Z') in the first direction (Z-Z').

8. The attachment structure according to any of claims 1 to 7, wherein the at least one cushion (200) has waterproofness.

9. The attachment structure according to any of claims 1 to 8, wherein
the detection sensor (100, 100') includes a first face on the other side (Z) in the first direction (Z-Z'),
the at least one cushion (200) includes a first face on the other side (Z) in the first direction (Z-Z') and a second face on the one side (Z') in the first direction (Z-Z'), and the second face of the at least one cushion (200) is in surface contact with the first face of the detection sensor (100, 100') or in contact with the first face of the detection sensor (100, 100') via an interlayer member (600),
the sensor unit (U1, U2, U3, U4) further includes at least one exhaust path (P), and
the at least one exhaust path (P) is provided in at least one face of the second face of the at least one cushion (200) or the first face of the detection sensor (100, 100'), opens out to the at least one face, and opens out to a side face or faces that meet the at least one face; or alternatively the at least one exhaust path (P) is provided in the interlayer member (600), opens out toward at least one face of the second face of the at least one cushion (200) or the first face of the detection sensor (100, 100'), and opens out to a side face of the interlayer member (600).

10. The attachment structure according to any of claims 1 to 8, wherein
the sensor unit (U3, U4) further comprising at least one intermediate part (700) arranged between the detection sensor (100, 100') and the at least one cushion (200).

11. The attachment structure according to claim 10, wherein
the at least one intermediate part (700) has waterproofness.

12. The attachment structure according to claim 10 or 11, wherein
the detection sensor (100, 100') includes a first face on the other side (Z) in the first direction (Z-Z'),
the at least one intermediate part (700) includes a first face on the other side (Z) in the first direction (Z-Z') and a second face on the one side (Z') in the first direction (Z-Z'), and the second face of the at least one intermediate part (700) is in surface contact with the first face of the detection sensor (100, 100') or in contact with the first face of the detection sensor (100, 100') via an interlayer member (600),
the sensor unit (U3, U4) further includes at least one exhaust path (P), and
the at least one exhaust path (P) is provided in at least one face of the second face of the at least one intermediate part (700) or the first face of the detection sensor (100, 100'), opens out to the at least one face, and opens out to a side face or faces that meet the at least one face; or alternatively the at least one exhaust path (P) is provided in the interlayer member (600), opens out toward at least one face of the second face of the at least one intermediate part (700) or the first face of the detection sensor (100, 100'), and opens out to a side face of the interlayer member (600).

13. The attachment structure according to any of claims 1 to 12, wherein
the at least one cushion (200) comprises a plurality of cushions (200) stacked in the first direction (Z-Z').

14. The attachment structure according to any of the preceding claims, wherein
the attachment target (T) further comprises a cushion layer (20),
the cushion layer (20) covers the housing (10) entirely from the other side (Z) in the first direction (Z-Z') and the outer surface layer (30) covers the cushion layer (20) and the housing (10) entirely or partly from the other side (Z) in the first direction (Z-Z'), or alternatively the cushion layer (20) covers the housing (10) partly from the other side (Z) in the first direction (Z-Z') and the outer surface layer (30) covers the cushion layer (20) and the housing (10) entirely or partly from the other side (Z) in the first direction (Z-Z'),
the hole (H) further includes a second hole (21), the second hole (21) extending through the cushion layer (20) in the first direction (Z-Z'), being located on the other side (Z) in the first direction (Z-Z') relative to the first hole (11), and communicating with the first hole (11),
the outer surface layer (30) closes the second hole (21) from the other side (Z) in the first direction (Z-Z'), and
the portion of the outer surface layer (30) that is located on other side (Z) in the first direction (Z-Z') relative to the hole (H) forms the bottom portion of the hole (H).

15. The attachment structure according to claim 14, wherein
the hole (H) is a blind hole with the second hole (21) opening out to the one side (Z') in the first direction (Z-Z') and being closed on the other side (Z) in the first direction (Z-Z'),
the cushion layer (20) includes a bottom portion (21a) on the other side (Z) in the first direction (Z-Z') in the second hole 21, and
the bottom portion of the hole (H) is constituted by the bottom portion (21a) and the portion of the outer surface layer (30) that is located on the other side (Z) in the first direction (Z-Z') relative to the hole (H).

## Patentansprüche

1. Befestigungsstruktur für eine Sensoreinheit (U1, U2, U3, U4) und ein Befestigungsziel (T), wobei die Befestigungsstruktur Folgendes umfasst:
Das Befestigungsziel (T) mit einem Loch (H), das sich mindestens zu einer Seite (Z') in einer ersten Richtung (Z-Z') öffnet, wobei das Befestigungsziel (T) Folgendes umfasst:
Ein Gehäuse (10), wobei das Loch (H) ein erstes Loch (11) einschließt, welches sich durch das Gehäuse (10) in erster Richtung (Z-Z') erstreckt, und
eine äußere Oberflächenschicht (30) aus einem natürlichen, künstlichen oder synthetischen Leder, einem Gewebe aus Fasermaterial, wie etwa einem gewebten oder gestrickten Stoff, oder einer Kunstharzfolie, die das Gehäuse (10) von der anderen Seite (Z) in der ersten Richtung (Z-Z') ganz oder teilweise bedeckt und das erste Loch (11) von der anderen Seite (Z) in der ersten Richtung (Z-Z') verschließt, wobei ein Teil der äußeren Oberflächenschicht (30), der sich auf der anderen Seite (Z) in der ersten Richtung (Z-Z') relativ zum ersten Loch (11) befindet, einen unteren Teil des Lochs Öffnung (H) bildet; und
die Sensoreinheit (U1, U2, U3, U4), welche von einer Seite (Z') in erster Richtung (Z-Z') an dem Befestigungsziel (T) angebracht ist, sodass sie von einer Seite (Z') in erster Richtung (Z-Z') teilweise im Loch (H) untergebracht ist, wobei die Sensoreinheit (U1, U2, U3, U4) umfasst:
Einen Detektionssensor (100, 100'), der ein Berührungssensor oder ein Drucksensor ist und so konfiguriert ist, dass er die Annäherung eines Detektionsziels von der anderen Seite (Z) in der ersten Richtung (Z-Z') erkennen kann; und
mindestens ein Polster (200), das den Detektionssensor (100, 100') zumindest teilweise von der anderen Seite (Z) in der ersten Richtung (Z-Z') bedeckt, wobei das mindestens eine Polster (200) zumindest teilweise im Loch (H) des Befestigungsziels (T) aufgenommen ist, in einem Zustand, in dem die Sensoreinheit (U1, U2, U3, U4) von der einen Seite (Z') in der ersten Richtung (Z-Z') am Befestigungsziel (T) befestigt ist.
wobei die erste Richtung (Z-Z') eine Richtung ist, entlang derer das mindestens eine Polster (200) und der Detektionssensor (100, 100') angeordnet sind.

2. Befestigungsstruktur nach Anspruch 1, wobei
die Sensoreinheit (U1, U2, U3, U4) ferner eine Abdeckung (500) umfasst, die das mindestens eine Polster (200) und den Detektionssensor (100, 100') von der anderen Seite (Z) in der ersten Richtung (Z-Z') abdeckt, und
die Abdeckung (500) oder das mindestens eine Polster (200) oder alternativ sowohl die Abdeckung (500) als auch das mindestens eine Polster (200) zumindest teilweise im Loch (H) des Befestigungsziels (T) untergebracht sind, und zwar in einem Zustand, in dem die Sensoreinheit (U1, U2, U3, U4) von einer Seite (Z') in der ersten Richtung (Z-Z') am Befestigungsziel (T) befestigt ist.

3. Befestigungsstruktur nach Anspruch 1 oder 2, wobei
die Sensoreinheit (U1, U3) ferner einen Körper (300) mit einer Halterung (310) umfasst,
die Halterung (310) ein Kasten ist, der sich in der ersten Richtung (Z-Z') zur anderen Seite (Z) hin öffnet, den Detektionssensor (100) und mindestens einen Teil des mindestens einen Polsters (200) aufnimmt und in dem sich die Halterung (310) zumindest teilweise im Loch (H) des Befestigungsziels (T) befindet, wenn die Sensoreinheit (U1, U3) von einer Seite (Z') in der ersten Richtung (Z-Z') am Befestigungsziel (T) befestigt ist.

4. Befestigungsstruktur nach Anspruch 1 oder 2, wobei
die Sensoreinheit (U1, U3) ferner einen Körper (300) umfasst, wobei der Körper (300) einschließt:
Eine Halterung (310), die sich auf der einen Seite (Z') in der ersten Richtung (Z-Z') relativ zum Detektionssensor (100) befindet und den Detektionssensor (100) hält, und
mindestens einen fixierbaren Abschnitt (320), der sich außerhalb des Detektionssensors (100) in einer im wesentlichen orthogonalen Richtung zur ersten Richtung (Z-Z') befindet und von einer Seite (Z') in der ersten Richtung (Z-Z') an dem Befestigungsziel (T) befestigt werden kann.

5. Befestigungsstruktur nach Anspruch 1 oder 2, wobei
die Sensoreinheit (U1, U3) ferner umfasst:
Einen Körper (300) mit einer Halterung (310), wobei sich die Halterung (310) auf der einen Seite (Z') in der ersten Richtung (Z-Z') relativ zum Detektionssensor (100) befindet und den Detektionssensor (100) hält; und
ein Befestigungselement, das am Körper (300) und von einer Seite (Z') in der ersten Richtung (Z-Z') am Befestigungsziel (T) befestigt ist.

6. Befestigungsstruktur nach Anspruch 1 oder 2, wobei
der Detektionssensor (100') einschließt:
Einen Sensorkörper (101), der als Berührungssensor oder Drucksensor fungiert und so konfiguriert ist, dass er die Annäherung eines Erfassungsziels von der anderen Seite (Z) in der ersten Richtung (Z-Z') erkennen kann; und
mindestens einen fixierbaren Abschnitt (102), der sich außerhalb des Sensorkörpers (101) in einer im wesentlichen orthogonalen Richtung zur ersten Richtung (Z-Z') befindet und von einer Seite (Z') in der ersten Richtung (Z-Z') an dem Befestigungsziel (T) befestigt werden kann.

7. Befestigungsstruktur nach Anspruch 1 oder 2, wobei
die Sensoreinheit (U2, U4) ferner ein Befestigungselement umfasst, und
das Befestigungselement am Detektionssensor (100') befestigt ist und von der einen Seite (Z') in der ersten Richtung (Z-Z') am Befestigungsziel (T) befestigt ist.

8. Befestigungsstruktur nach einem der Ansprüche 1 bis 7, wobei das mindestens eine Polster (200) wasserdicht ist.

9. Befestigungsstruktur nach einem der Ansprüche 1 bis 8, wobei
der Detektionssensor (100, 100') umfasst eine erste Fläche auf der anderen Seite (Z) in der ersten Richtung (Z-Z'),
das mindestens eine Polster (200) eine erste Fläche auf der anderen Seite (Z) in der ersten Richtung (Z-Z') und eine zweite Fläche auf der einen Seite (Z') in der ersten Richtung (Z-Z') aufweist, wobei die zweite Fläche des mindestens einen Polsters (200) entweder in Oberflächenkontakt mit der ersten Fläche des Detektionssensors (100, 100') steht oder über ein Zwischenschichtelement (600) mit der ersten Fläche des Detektionssensors (100, 100') in Kontakt steht,
die Sensoreinheit (U1, U2, U3, U4) ferner mindestens einen Abgaskanal (P) umfasst, und
der mindestens eine Abgaskanal (P) in mindestens einer Seite der zweiten Seite des mindestens einen Polsters (200) oder der ersten Seite des Detektionssensors (100, 100') vorgesehen ist, sich zu dieser mindestens einen Seite und zu einer oder mehreren Seitenflächen öffnet, die an diese mindestens eine Seite angrenzen; oder alternativ der mindestens eine Abgaskanal (P) im Zwischenschichtelement (600) vorgesehen ist, sich zu mindestens einer Seite der zweiten Seite des mindestens einen Polsters (200) oder der ersten Seite des Detektionssensors (100, 100') und zu einer Seitenfläche des Zwischenschichtelements (600) öffnet.

10. Befestigungsstruktur nach einem der Ansprüche 1 bis 8, wobei
die Sensoreinheit (U3, U4) ferner mindestens ein Zwischenteil (700) umfasst, das zwischen dem Detektionssensor (100, 100') und dem mindestens einen Polster (200) angeordnet ist.

11. Befestigungsstruktur nach Anspruch 10, wobei
das mindestens eine Zwischenteil (700) wasserdicht ist.

12. Befestigungsstruktur nach Anspruch 10 oder 11, wobei
der Detektionssensor (100, 100') eine erste Fläche auf der anderen Seite (Z) in der ersten Richtung (Z-Z') umfasst,
das mindestens eine Zwischenteil (700) eine erste Fläche auf der anderen Seite (Z) in der ersten Richtung (Z-Z') und eine zweite Fläche auf der einen Seite (Z') in der ersten Richtung (Z-Z') umfasst, wobei die zweite Fläche des mindestens einen Zwischenteils (700) entweder in Oberflächenkontakt mit der ersten Fläche des Detektionssensors (100, 100') steht oder über ein Zwischenschichtelement (600) mit der ersten Fläche des Detektionssensors (100, 100') in Kontakt steht,
die Sensoreinheit (U3, U4) ferner mindestens einen Abgaskanal (P) umfasst, und
der mindestens eine Abgaskanal (P) in mindestens einer Seite der zweiten Seite des mindestens einen Zwischenteils (700) oder der ersten Seite des Detektionssensors (100, 100') vorgesehen ist, sich zu dieser mindestens einen Seite und zu einer oder mehreren Seitenflächen öffnet, die an diese mindestens eine Seite angrenzen; oder alternativ der mindestens eine Abgaskanal (P) im Zwischenschichtelement (600) vorgesehen ist, sich zu mindestens einer Seite der zweiten Seite des mindestens einen Polsters (700) oder der ersten Seite des Detektionssensors (100, 100') und zu einer Seitenfläche des Zwischenschichtelements (600) öffnet.

13. Befestigungsstruktur nach einem der Ansprüche 1 bis 12, wobei
das mindestens eine Polster (200) aus einer Vielzahl von Polstern (200) besteht, die in der ersten Richtung (Z-Z') gestapelt sind.

14. Befestigungsstruktur nach einem beliebigen der vorhergehenden Ansprüche, wobei
das Befestigungsziel (T) ferner eine Polsterschicht (20) umfasst,
die Polsterschicht (20) das Gehäuse (10) vollständig von der anderen Seite (Z) in der ersten Richtung (Z-Z') bedeckt, und die äußere Oberflächenschicht (30) die Polsterschicht (20) und das Gehäuse (10) vollständig oder teilweise von der anderen Seite (Z) in der ersten Richtung (Z-Z') bedeckt, oder alternativ die Polsterschicht (20) das Gehäuse (10) teilweise von der anderen Seite (Z) in der ersten Richtung (Z-Z') bedeckt, und die äußere Oberflächenschicht (30) die Polsterschicht (20) und das Gehäuse (10) vollständig oder teilweise von der anderen Seite (Z) in der ersten Richtung (Z-Z') bedeckt,
das Loch (H) ferner ein zweites Loch (21) umfasst, wobei sich das zweite Loch (21) in erster Richtung (Z-Z') durch die Polsterschicht (20) erstreckt, sich auf der anderen Seite (Z) in erster Richtung (Z-Z') relativ zum ersten Loch (11) befindet und mit dem ersten Loch (11) in Verbindung steht,
die äußere Oberflächenschicht (30) das zweite Loch (21) von der anderen Seite (Z) in der ersten Richtung (Z-Z') verschließt, und
der Teil der äußeren Oberflächenschicht (30), der sich auf der anderen Seite (Z) in der ersten Richtung (Z-Z') relativ zum Loch (H) befindet, den unteren Teil des Lochs (H) bildet.

15. Befestigungsstruktur nach Anspruch 14, wobei
das Loch (H) ein Sackloch ist, wobei sich das zweite Loch (21) auf der einen Seite (Z') in der ersten Richtung (Z-Z') öffnet und auf der anderen Seite (Z) in der ersten Richtung (Z-Z') geschlossen ist,
die Polsterschicht (20) einen unteren Abschnitt (21a) auf der anderen Seite (Z) in der ersten Richtung (Z-Z') im zweiten Loch 21 umfasst, und
der untere Abschnitt des Lochs (H) aus dem unteren Abschnitt (21a) und dem Abschnitt der äußeren Oberflächenschicht (30) besteht, der sich auf der anderen Seite (Z) in der ersten Richtung (Z- Z') relativ zum Loch (H) befindet.

## Revendications

1. Structure de fixation pour une unité de capteur (U1, U2, U3, U4) et une cible de fixation (T), la structure de fixation comprenant :
la cible de fixation (T) ayant un trou (H) s'ouvrant sur au moins un côté (Z') dans une première direction (Z-Z'), la cible de fixation (T) comprenant :
un logement (10), le trou (H) incluant un premier trou (11) s'étendant à travers le logement (10) dans la première direction (Z-Z'), et
une couche de surface externe (30) qui est composée d'un cuir naturel, artificiel ou synthétique, d'un tissu de matière fibreuse, par exemple un tissu tissé ou un tissu maille, d'un film de résine synthétique, couvrant le logement (10) entièrement ou partiellement à partir de l'autre côté (Z) dans la première direction (Z-Z'), et fermant le premier trou (11) à partir de l'autre côté (Z) dans la première direction (Z-Z'), où une portion de la couche de surface externe (30) qui est située sur l'autre côté (Z) dans la première direction (Z-Z') relativement au premier trou (11) forme une portion inférieure du trou (H) ; et
l'unité de capteur (U1, U2, U3, U4) est fixée à la cible de fixation (T) à partir de cet un côté (Z') dans la première direction (Z-Z') de sorte à être partiellement reçue, à partir de cet un côté (Z') dans la première direction (Z-Z'), dans le trou (H), l'unité de capteur (U1, U2, U3, U4) comprenant :
un capteur de détection (100, 100') qui est un capteur tactile ou un capteur de pression et est configuré pour être apte à détecter une approche d'une cible de détection à partir de l'autre côté (Z) dans la première direction (Z-Z') ; et
au moins un coussinet (200) couvrant le capteur de détection (100, 100') au moins partiellement à partir de l'autre côté (Z) dans la première direction (Z-Z'), où l'au moins un coussinet (200) est au moins partiellement reçu dans le trou (H) de la cible de fixation (T) dans un état dans lequel l'unité de capteur (U1, U2, U3, U4) est fixée à la cible de fixation (T) à partir de cet un côté (Z') dans la première direction (Z-Z'),
où la première direction (Z-Z') est une direction le long de laquelle l'au moins un coussinet (200) et le capteur de détection (100, 100') sont agencés.

2. Structure de fixation selon la revendication 1, où
l'unité de capteur (U1, U2, U3, U4) comprend en outre une couverture (500) couvrant l'au moins un coussinet (200) et le capteur de détection (100, 100') à partir de l'autre côté (Z) dans la première direction (Z-Z'), et
la couverture (500) ou l'au moins un coussinet (200), ou alternativement à la fois la couverture (500) et l'au moins un coussinet (200), sont au moins partiellement reçus dans le trou (H) de la cible de fixation (T) dans un état dans lequel l'unité de capteur (U1, U2, U3, U4) est fixée à la cible de fixation (T) à partir de cet un côté (Z') dans la première direction (Z-Z').

3. Structure de fixation selon la revendication 1 ou 2, où
l'unité de capteur (U1, U3) comprend en outre un corps (300) incluant un support (310),
le support (310) est une boîte s'ouvrant sur l'autre côté (Z) dans la première direction (Z-Z'), reçoit le capteur de détection (100) et au moins une partie de l'au moins un coussinet (200), et le support (310) est au moins partiellement reçu dans le trou (H) de la cible de fixation (T) dans un état dans lequel l'unité de capteur (U1, U3) est fixée à la cible de fixation (T) à partir de cet un côté (Z') dans la première direction (Z-Z').

4. Structure de fixation selon la revendication 1 ou 2, où
l'unité de capteur (U1, U3) comprend en outre un corps (300), le corps (300) incluant :
un support (310) qui est situé sur cet un côté (Z') dans la première direction (Z-Z') relativement au capteur de détection (100) et maintenant le capteur de détection (100) et
au moins une portion fixable (320) qui est située à l'extérieur du capteur de détection (100) dans une direction substantiellement orthogonale à la première direction (Z-Z') et fixable à la cible de fixation (T) à partir de cet un côté (Z') dans la première direction (Z-Z').

5. Structure de fixation selon la revendication 1 ou 2, où
l'unité de capteur (U1, U3) comprend en outre :
un corps (300) incluant un support (310), le support (310) étant situé sur cet un côté (Z') dans la première direction (Z-Z') relativement au capteur de détection (100) et maintenant le capteur de détection (100) ; et
un élément de fixation qui fixé au corps (300) et est fixé à la cible de fixation (T) à partir de cet un côté (Z') dans la première direction (Z-Z').

6. Structure de fixation selon la revendication 1 ou 2, où
le capteur de détection (100') inclut :
un corps de capteur (101) qui est le capteur tactile ou le capteur de pression et est configuré pour être apte à détecter une approche d'une cible de détection à partir de l'autre côté (Z) dans la première direction (Z-Z') ; et
au moins une portion fixable (102) qui est située à l'extérieur du corps de capteur (101) dans une direction substantiellement orthogonale à la première direction (Z-Z') et fixée à la cible de fixation (T) à partir de cet un côté (Z') dans la première direction (Z-Z').

7. Structure de fixation selon la revendication 1 ou 2, où
l'unité de capteur (U2, U4) comprend en outre un élément de fixation, et
l'élément de fixation est fixé au capteur de détection (100') et est fixé à la cible de fixation (T) à partir de cet un côté (Z') dans la première direction (Z-Z').

8. Structure de fixation selon n'importe lesquelles des revendications 1 à 7, où l'au moins un coussinet (200) présente une imperméabilité à l'eau.

9. Structure de fixation selon n'importe lesquelles des revendications 1 à 8, où
le capteur de détection (100, 100') inclut une première face sur l'autre côté (Z) dans la première direction (Z-Z'),
l'au moins un coussinet (200) inclut une première face sur l'autre côté (Z) dans la première direction (Z-Z') et une deuxième face sur cet un côté (Z') dans la première direction (Z-Z'), et la deuxième face de l'au moins un coussinet (200) est en contact superficiel avec la première face du capteur de détection (100, 100') ou en contact avec la première face du capteur de détection (100, 100') via un élément de couche intercalaire (600),
l'unité de capteur (U1, U2, U3, U4) inclut en outre au moins un chemin d'échappement (P), et
l'au moins un chemin d'échappement (P) est prévu dans au moins une face de la deuxième face de l'au moins un coussinet (200) ou la première face du capteur de détection (100, 100'), s'ouvre sur l'au moins une face, et s'ouvre sur une face latérale ou des faces qui jouxtent l'au moins une face ; ou alternativement l'au moins un chemin d'échappement (P) est prévu dans l'élément de couche intercalaire (600), s'ouvre vers au moins une face de la deuxième face de l'au moins un coussinet (200) ou la première face du capteur de détection (100, 100'), et s'ouvre sur une face latérale de l'élément de couche intercalaire (600).

10. Structure de fixation selon n'importe lesquelles des revendications 1 à 8, où
l'unité de capteur (U3, U4) comprend en outre au moins une partie intermédiaire (700) agencée entre le capteur de détection (100, 100') et l'au moins un coussinet (200).

11. Structure de fixation selon la revendication 10, où
l'au moins une partie intermédiaire (700) présente une imperméabilité à l'eau.

12. Structure de fixation selon la revendication 10 ou 11, où
le capteur de détection (100, 100') inclut une première face sur l'autre côté (Z) dans la première direction (Z-Z'),
l'au moins une partie intermédiaire (700) inclut une première face sur l'autre côté (Z) dans la première direction (Z-Z') et une deuxième face sur cet un côté (Z') dans la première direction (Z-Z'), et la deuxième face de l'au moins une partie intermédiaire (700) est en contact superficiel avec la première face du capteur de détection (100, 100') ou en contact avec la première face du capteur de détection (100, 100') via un élément de couche intercalaire (600),
l'unité de capteur (U3, U4) inclut en outre au moins un chemin d'échappement (P), et
l'au moins un chemin d'échappement (P) est prévu dans au moins une face de la deuxième face de l'au moins une partie intermédiaire (700) ou la première face du capteur de détection (100, 100'), s'ouvre sur l'au moins une face, et s'ouvre sur une face latérale ou des faces qui jouxtent l'au moins une face ; ou alternativement l'au moins un chemin d'échappement (P) est prévu dans l'élément de couche intercalaire (600), s'ouvre vers au moins une face de la deuxième face de l'au moins une partie intermédiaire (700) ou la première face du capteur de détection (100, 100'), et s'ouvre sur une face latérale de l'élément de couche intercalaire (600).

13. Structure de fixation selon n'importe lesquelles des revendications 1 à 12, où
l'au moins un coussinet (200) comprend une pluralité de coussinets (200) qui sont empilés dans la première direction (Z-Z').

14. Structure de fixation selon n'importe lesquelles des revendications précédentes, où
la cible de fixation (T) comprend en outre une couche formant coussinet (20),
la couche formant coussinet (20) couvre le logement (10) entièrement à partir de l'autre côté (Z) dans la première direction (Z-Z') et la couche de surface externe (30) couvre la couche formant coussinet (20) et le logement (10) entièrement ou partiellement à partir de l'autre côté (Z) dans la première direction (Z-Z'), ou alternativement la couche formant coussinet (20) couvre le logement (10) partiellement à partir de l'autre côté (Z) dans la première direction (Z-Z') et la couche de surface externe (30) couvre la couche formant coussinet (20) et le logement (10) entièrement ou partiellement à partir de l'autre côté (Z) dans la première direction (Z-Z'),
le trou (H) inclut en outre un deuxième trou (21), le deuxième trou (21) s'étendant à travers la couche formant coussinet (20) dans la première direction (Z-Z'), étant situé sur l'autre côté (Z) dans la première direction (Z-Z') relativement au premier trou (11), et en communication avec le premier trou (11),
la couche de surface externe (30) ferme le deuxième trou (21) à partir de l'autre côté (Z) dans la première direction (Z-Z'), et
la portion de la couche de surface externe (30) qui est située sur l'autre côté (Z) dans la première direction (Z-Z') relativement au trou (H) forme la portion inférieure du trou (H).

15. Structure de fixation selon la revendication 14, où
le trou (H) est un trou borgne alors que le deuxième trou (21) s'ouvre sur cet un côté (Z') dans la première direction (Z-Z') et est fermé sur l'autre côté (Z) dans la première direction (Z-Z'),
la couche formant coussinet (20) inclut une portion inférieure (21a) sur l'autre côté (Z) dans la première direction (Z-Z') dans le deuxième trou (21), et
la portion inférieure du trou (H) est constituée par la portion inférieure (21a) et la portion de la couche de surface externe (30) qui est située sur l'autre côté (Z) dans la première direction (Z-Z') relativement au trou (H).
